(19) Europäisches Patentamt / European Patent Office / Office européen des brevets

(11) **EP 3 432 368 B1**

(12) **FASCICULE DE BREVET EUROPEEN**

(45) Date de publication et mention
de la délivrance du brevet:
**29.12.2021 Bulletin 2021/52**

(51) Int Cl.:
*H01L 33/20* (2010.01)          *H01L 33/38* (2010.01)
*H01L 33/10* (2010.01)          *H01L 33/00* (2010.01)
*H01L 33/46* (2010.01)

(21) Numéro de dépôt: **18183183.5**

(22) Date de dépôt: **12.07.2018**

(54) **DIODE ÉLECTROLUMINESCENTE COMPORTANT UN EMPILEMENT À PARTIE AMINCIE ET PROCÉDÉ D'ÉLABORATION CORRESPONDANT**

LEUCHTDIODE, DIE EINEN STAPEL MIT VERDÜNNTEM TEIL UMFASST, UND DEREN HERSTELLUNGSVERFAHREN

LIGHT EMITTING DIODE COMPRISING A STACK WITH A THINNED PORTION AND METHOD OF MANUFACTURING THE SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.07.2017 FR 1756778**

(43) Date de publication de la demande:
**23.01.2019 Bulletin 2019/04**

(73) Titulaire: **Commissariat à l'Énergie Atomique et aux Énergies Alternatives**
**75015 Paris (FR)**

(72) Inventeur: **VAUFREY, David**
**38000 GRENOBLE (FR)**

(74) Mandataire: **Germain Maureau**
**12, rue Boileau**
**69006 Lyon (FR)**

(56) Documents cités:
EP-A1- 2 846 366          JP-A- H0 786 635
US-A- 4 700 210          US-A- 4 990 972
US-A1- 2002 047 131          US-A1- 2002 113 235
US-A1- 2012 037 885

• ROEL G. BAETS ET AL: "Resonant-Cavity Light-Emitting Diodes: a review", PROCEEDINGS OF SPIE, vol. 4996, 9 juillet 2003 (2003-07-09), pages 74-86, XP055528727, 1000 20th St. Bellingham WA 98225-6705 USA ISSN: 0277-786X, DOI: 10.1117/12.476588

**Description**

**Domaine de l'invention**

Le domaine de l'invention concerne les diodes électroluminescentes, notamment à base de semi-conducteurs inorganiques.

**Etat de la technique**

L'efficacité d'une diode électroluminescente peut être accrue en jouant sur différentes caractéristiques de cette dernière.

Par exemple, il est connu de mettre en œuvre une texturation formant une rugosité sur une surface d'émission d'une couche de GaN (nitrure de gallium) dopé de type N d'un empilement d'une diode électroluminescente comme l'enseigne le document « Increase in the extraction efficiency of GaN-based light-emitting diodes via surface roughening » de T. Fujii et al. publié dans Applied Physics Letters volume 84, numéro 6, le 9 février 2004 en pages 855 à 857. Une telle texturation permet de limiter les réflexions de lumière internes à l'empilement, et de diffuser cette lumière vers l'extérieur de l'empilement.

Bien que la texturation de la diode électroluminescente permette d'améliorer l'extraction des photons, elle se limite à améliorer l'extraction des photons qui atteignent la surface d'émission. En ce sens, on comprend qu'il existe un besoin d'améliorer la quantité de photons qui atteignent la surface d'émission de la diode électroluminescente.

Le document « Evaluation of InGaN/GaN light-emitting diodes of circular geometry » de X. H. Wang et al. publié dans Optics Express Vol. 17, issue 25 pp. 22311-22319 (2009) décrit que la forme d'une diode électroluminescente peut avoir une influence sur l'extraction de la lumière générée par la diode électroluminescente. En effet, dans un empilement d'une diode électroluminescente, des photons peuvent être générés, de préférence par des puits quantiques, et se propagent ensuite selon des directions différentes. Selon ce document, l'extraction par le haut peut se faire via des émissions de photons réalisées selon un angle solide associé, et lorsque les photons sont émis en dehors de cet angle solide, ils peuvent s'échapper via les flancs de la diode électroluminescente, ou peuvent être réfléchis au sein de la diode électroluminescente. En somme, sans disposition particulière visant à accroître l'extraction de la diode électroluminescente, seuls les photons émis selon un angle solide particulier sont pris en compte pour le calcul de l'efficacité de la diode électroluminescente si l'on mesure cette efficacité de la diode électroluminescente pour un côté, généralement par le haut ou « top surface » en anglais. On comprend qu'il existe aussi un besoin d'améliorer l'efficacité de la diode électroluminescente, notamment en augmentant l'extraction des photons émis par la diode électroluminescente, en particulier depuis un même côté de la diode électroluminescente.

Les documents US 4 990 972 A, US 2002/0047131 A1, JP H07-86635 A, EP 2 846 366 A1, US 4 700 210 A, US 2002/0113235 A1 et US 2012/0037885 A1 décrivent des diodes électroluminescentes dont la forme ou la structure interne permettent d'augmenter l'extraction lumineuse et/ou l'efficacité d'injection des porteurs.

Par ailleurs, le document "Resonant-Cavity Light-Emitting Diodes: a review" de R. G. Baets et al. publié dans Proceedings of SPIE volume 4996, le 9 juillet 2003, pp. 74-86, décrit l'état de la technique concernant les diodes électroluminescentes à cavité résonante. Toutefois, l'efficacité d'injection des porteurs dans de telles diodes électroluminescentes à cavité résonante n'y est pas abordée.

En ce sens, on comprend clairement qu'il existe un besoin de développer une nouvelle structure de diode électroluminescente répondant à la problématique générale de l'amélioration de l'efficacité de la diode électroluminescente, notamment par l'optimisation de l'extraction optique de la diode électroluminescente.

**Objet de l'invention**

L'invention a pour but de répondre à tout ou partie des besoins évoqués ci-dessus.

Pour tendre vers ce but, l'invention a pour objet une diode électroluminescente selon la présente revendication 1 comportant:

- un empilement de couches semi-conductrices comprenant une première face et une deuxième face opposées selon une épaisseur de l'empilement,
- une première électrode comportant une face en contact avec la première face de l'empilement, et
- une deuxième électrode en contact avec l'empilement, l'empilement comportant une région active apte à générer des photons, une couche en matériau semi-conducteur dopé de premier type et une couche en matériau semi-conducteur dopé de second type, un évidement étant formé dans la deuxième face de l'empilement d'où il résulte que l'empilement comporte une partie amincie, la face de la première électrode en contact avec la première face étant en contact uniquement avec la partie amincie de l'empilement, la deuxième électrode étant en contact avec une zone de l'empilement distincte de ladite partie amincie de l'empilement,

l'empilement présentant une première épaisseur entre ses première et deuxième faces et une deuxième épaisseur *d* entre un fond de l'évidement et la première face, la deuxième épaisseur d étant strictement inférieure à la première épaisseur, la partie amincie de l'empilement comportant une première partie reliant la première électrode à une zone située dans la région active de l'empilement et une deuxième partie s'étendant de la première partie jusqu'au fond de l'évidement,

la diode électroluminescente étant caractérisée en ce que l'évidement est formé dans la couche en matériau semi-conducteur dopé de premier type qui présente une conductivité électrique strictement supérieure à la conductivité électrique de la couche en matériau semi-conducteur dopé de second type, et en ce que la deuxième épaisseur d satisfait l'équation suivante :

$$d = z + L \; \P$$

avec $z = k_z . \lambda/2n$, $d = k_d . \lambda/2n$ et $L$ étant tel que $\lambda/2n . (k_d - k_z) = L$ avec $k_d > k_z$, $k_d$ et $k_z$ étant des entiers positifs différents de 0, $\lambda$ étant une longueur d'onde d'émission principale en fonctionnement de la diode électroluminescente, et *n* étant un indice optique de l'empilement déterminé à la longueur d'onde d'émission principale, la première partie présentant une épaisseur égale à z et la deuxième partie présentant une épaisseur égale à *L.*

Ceci permet notamment d'améliorer l'efficacité de l'extraction de la diode électroluminescente tout en conservant une distribution spatiale convenable du courant au sein de la diode électroluminescente en fonctionnement.

Divers modes de réalisation avantageux de la diode électroluminescente selon la présente invention font l'objet des revendications dépendantes de produit 2 à 8 en annexe.

L'invention a également pour objet un procédé d'élaboration d'une diode électroluminescente selon la présente revendication 9, ladite diode électroluminescente à élaborer comportant :

- un empilement de couches semi-conductrices comprenant une première face et une deuxième face opposées selon une épaisseur de l'empilement,
- une première électrode comportant une face en contact avec la première face de l'empilement, et
- une deuxième électrode,

l'empilement comportant une région active apte à générer des photons, une couche en matériau semi-conducteur dopé de premier type et une couche en matériau semi-conducteur dopé de second type, le procédé d'élaboration comportant une étape de conception de l'empilement dont la deuxième face présente un évidement pour former une partie amincie de l'empilement, l'étape de conception prenant en compte les caractéristiques suivantes :

- ladite face de la première électrode de la diode électroluminescente est destinée à être en contact uniquement avec la partie amincie de l'empilement,
- la deuxième électrode de la diode électroluminescente est destinée à être en contact avec une zone de l'empilement distincte de ladite partie amincie de l'empilement,

le procédé d'élaboration étant caractérisé en ce que :

- l'évidement est formé dans la couche en matériau semi-conducteur dopé de premier type qui présente une conductivité électrique strictement supérieure à la conductivité électrique de la couche en matériau semi-conducteur dopé de second type,
- l'étape de conception prend en compte le fait que la partie amincie de l'empilement comporte une première partie reliant la première électrode à une zone située dans la région active de l'empilement et une deuxième partie s'étendant de la première partie jusqu'au fond de l'évidement,
- l'étape de conception de l'empilement comporte les étapes suivantes :

  ○ une étape de détermination d'une longueur d'onde d'émission principale $\lambda$ de la diode électroluminescente lors de son fonctionnement,

  ○ une étape de détermination, à la longueur d'onde d'émission principale, d'un indice optique n de l'empilement,

○ une étape de détermination d'une épaisseur d de la partie amincie entre la première face et un fond de l'évidement, l'épaisseur d satisfaisant $d = z + L$ avec $z = k_z \cdot \frac{\lambda}{2n}$ , $d = k_d \cdot \frac{\lambda}{2n}$ , et $L$ étant tel que $\frac{\lambda}{2n} \cdot (k_d - k_z) = L$ ,

avec $k_d > k_z$, $k_d$ et $k_z$ étant des entiers positifs différents de 0, la première partie présentant une épaisseur égale à $z$ et la deuxième partie présentant une épaisseur égale à $L$.

Divers modes de réalisation avantageux du procédé d'élaboration de la diode électroluminescente selon la présente invention font l'objet des revendications dépendantes de procédé 10 et 11 en annexe.

## Description sommaire des dessins

L'invention sera mieux comprise à la lecture de la description qui va suivre, donnée uniquement à titre d'exemple non limitatif et faite en se référant aux figures pour lesquelles :

- La figure 1 illustre une vue en coupe d'une diode électroluminescente selon un mode de réalisation particulier de l'invention,
- La figure 2 est une vue en perspective de la diode électroluminescente de la figure 1,
- La figure 3 est une vue en coupe de la diode électroluminescente du type de la figure 1 pour laquelle les hachures ont été retirées pour faire apparaitre des lignes de courant,
- La figure 4 illustre une alternative de réalisation de la diode électroluminescente vue par le dessus,
- La figure 5 illustre, vue en coupe, une partie des couches de l'empilement de la diode électroluminescente,
- Les figures 6 à 10 sont des vues en coupes de différents modes de réalisation de la diode électroluminescente,
- La figure 11 illustre schématiquement des étapes d'un procédé d'élaboration de la diode électroluminescente.

Dans ces figures, les mêmes références sont utilisées pour désigner les mêmes éléments.
Par ailleurs, les différents éléments représentés sur les figures ne sont pas nécessairement représentés selon une échelle uniforme pour rendre les figures plus lisibles.

## Description de modes particuliers de réalisation

Dans le cadre de la présente invention, on cherche à réaliser une diode électroluminescente (LED pour « Light Emitting Diode ») dont la structure tend à concentrer des photons émis depuis une région active d'un empilement de couches semi-conductrices de la diode électroluminescente, notamment par des puits quantiques, dans un angle solide pour lequel les photons émis s'échappent par une surface supérieure d'émission, ou plus généralement une surface d'émission de la diode électroluminescente. Cette surface d'émission peut être située d'un côté de la diode électroluminescente opposé à une anode de la diode électroluminescente pour une LED à base de GaN (nitrure de gallium) ou AlGaN (nitrure d'aluminium-gallium). Pour optimiser le fonctionnement de la LED, une première électrode peut être en contact avec une couche de transport de porteurs de charge de l'empilement présentant une première conductivité électrique, alors qu'une deuxième électrode peut être en contact avec une autre couche de transport de porteurs de charge de l'empilement présentant une deuxième conductivité électrique strictement supérieure à la première conductivité électrique. Notamment, la surface de contact de la première électrode avec l'empilement est strictement supérieure à la surface de contact de la deuxième électrode avec l'empilement. Une telle structure peut être obtenue en limitant l'épaisseur d'une partie de l'empilement qui comporte alors la surface d'émission.
Pour répondre à la problématique d'amélioration de l'efficacité de l'extraction de la diode électroluminescente, il est proposé de limiter l'épaisseur d'une partie de l'empilement, tout en conservant une distribution spatiale convenable du courant au sein de la diode électroluminescente en fonctionnement.
Une diode électroluminescente est un dispositif permettant de générer des ondes électromagnétiques, par exemple centrées sur une longueur d'onde particulière, ou de la lumière dans le spectre visible ou non. Autrement dit, une diode électroluminescente est configurée pour émettre des photons. De préférence, l'amincissement proposé permet judicieusement de tenir compte des interférences entre les ondes électromagnétiques émises directes et les ondes électromagnétiques réfléchies sur la première électrode, ainsi que des interférences entre les ondes électromagnétiques émises au sein de l'empilement induites par la cavité optique de la diode électroluminescente en vue d'améliorer l'extraction des photons, et donc l'efficacité de la diode électroluminescente. L'efficacité d'extraction d'une diode électroluminescente peut être vue comme le nombre de photons qui sortent de la diode électroluminescente par rapport au nombre de photons générés dans la diode électroluminescente. Par ailleurs, la conservation de la distribution spatiale convenable du courant est quant à elle mise en œuvre par un agencement particulier des contacts électriques (anode et cathode) adapté aux contraintes imposées par les conditions d'interférences constructives, donc par la présence de cette partie amincie de l'empilement.

Dans la présente description, lorsqu'il est fait référence à une longueur d'onde d'émission principale de la diode électroluminescente (aussi appelée longueur d'onde d'émission principale en fonctionnement de la diode électroluminescente ou longueur d'onde d'émission principale de la diode électroluminescente lors de son fonctionnement), il s'agit de la longueur d'onde du maximum du spectre d'électroluminescence de la diode électroluminescente.

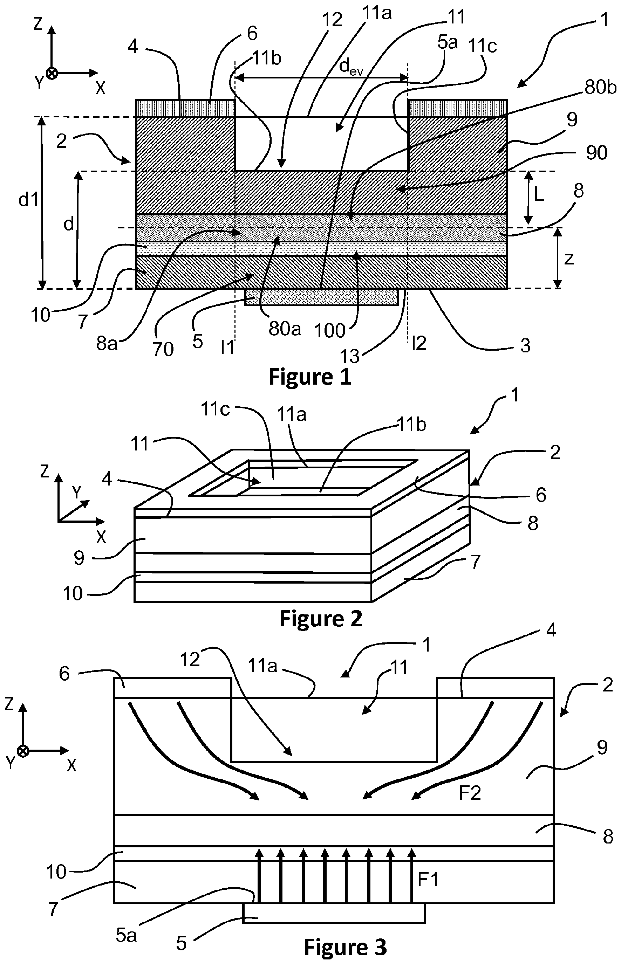

Sur les figures 1 à 10, il est représenté un repère orthogonal tridimensionnel d'axes X, Y, Z, les axes X, Y et Z étant orthogonaux entre eux et s'étendant depuis une même origine. Les axes X et Y définissent un plan considéré comme parallèle à l'horizontal du référentiel de la diode électroluminescente 1. L'axe Z est dirigé vers le haut, et permet de représenter une direction verticale de la diode électroluminescente 1. Notamment, l'axe Z est orthogonal au plan d'émission de la diode électroluminescente 1, c'est-à-dire au plan par lequel les photons émis par la diode électroluminescente 1 s'échappent. C'est notamment selon cette direction verticale que l'on peut interpréter les termes « au-dessus de » et « à l'aplomb de ». Les figures 1, 3, 5, 6, 7, 8, 9 et 10 sont des vues en coupe selon un plan de coupe parallèle au plan défini par les axes X et Z.

Dans la présente description, l'empilement de couches semi-conductrices de la diode électroluminescente 1 est associé à une direction d'empilement qui correspond à l'axe selon lequel les couches semi-conductrices de l'empilement sont empilées. La notion d'épaisseur utilisée dans la présente description est liée à l'axe Z, et se mesure selon un axe parallèle à l'axe Z, c'est-à-dire selon un axe parallèle à la direction d'empilement des couches semi-conductrices de l'empilement de couches.

Dans la présente description, par la formulation « A à base de B » on entend que B entre majoritairement dans la composition de A.

Dans la présente description, une surface d'émission correspond à une surface de l'empilement de couches semi-conductrices de la diode électroluminescente par laquelle s'échappent les photons générés au sein de l'empilement. Cette surface d'émission est située d'un côté de la diode électroluminescente, aussi appelé face d'émission de la diode électroluminescente, et permet de définir le plan d'émission évoqué ci-avant.

La notion d'interférence entre les ondes électromagnétiques émises directes et les ondes électromagnétiques émises indirectes (celles réfléchies) est une notion connue de l'homme du métier sous les termes « miroir de Lloyd » qui décrit un phénomène d'interférences entre un point source émetteur de photons et un miroir. En considérant le miroir comme étant la première électrode, et le point source comme étant l'endroit émetteur de photons le plus proche du miroir, l'ajustement de la distance de séparation entre le miroir et le point source peut permettre de générer des interférences constructives en vue d'optimiser l'extraction de ces ondes de l'empilement de la diode électroluminescente via la surface d'émission, notamment située à l'aplomb de la première électrode.

La notion d'interférences induites par la cavité est connue de l'homme du métier, notamment selon le principe de l'interféromètre de Fabry-Perot. La cavité optique dans le cadre de l'empilement de la diode électroluminescente peut être constituée par toutes les parties de l'empilement qui se trouvent à l'aplomb de la première électrode.

En étudiant ces deux notions d'interférences et les expressions des différences de chemins optiques qui en résultent, on peut conclure que ces deux types d'interférences peuvent être optimisés indépendamment l'un de l'autre, mais que leur combinaison agit en synergie pour améliorer l'efficacité d'extraction de la diode électroluminescente. Cependant, on constate que l'optimisation conduit à diminuer l'épaisseur usuelle de l'empilement de couches semi-conductrices de la diode électroluminescente, notamment en diminuant l'épaisseur d'une couche de transport de trous et d'une couche de transport d'électrons de l'empilement. La diminution de l'épaisseur évoquée ci-dessus permet d'améliorer l'efficacité d'extraction des photons générés, mais se fait au détriment de la répartition spatiale du courant dans l'empilement lorsque la diode électroluminescente est en fonctionnement : il en résulte que les porteurs de charge se concentrent dans les zones les plus proches des électrodes. En conséquence, une part significative de la région active de l'empilement apte à générer des photons n'est pas ou peu traversée par un courant susceptible de générer les photons. En fait, nombre de diodes électroluminescentes souffrent d'une chute d'efficacité à forte injection : en conséquence il toujours souhaitable d'uniformiser le courant traversant la LED.

En ce sens, la présente invention propose une nouvelle structure de diode électroluminescente permettant notamment d'améliorer l'efficacité d'extraction de photons au niveau d'un même côté de la diode électroluminescente. Une telle structure peut être mise en œuvre par l'empilement de couches semi-conductrices à partie amincie, et par une coopération judicieuse des électrodes de la diode électroluminescente avec cet empilement de couches semi-conductrices. En particulier, il est proposé que l'empilement comporte une partie amincie en contact avec une anode, par exemple dans le cas de LED à base de GaN, ou en contact avec une cathode, par exemple dans le cas de LED à base de InP, et de positionner la cathode (LED à base de GaN), ou le cas échéant l'anode (par exemple LED à base de InP) hors de la partie amincie afin d'améliorer la répartition du courant lors du fonctionnement de la diode électroluminescente.

Comme illustré en figure 1, la diode électroluminescente 1 comporte l'empilement 2 de couches semi-conductrices. Cet empilement 2 de couches semi-conductrices comprend une première face 3 et une deuxième face 4. Notamment, ces couches semi-conductrices sont inorganiques. Les couches semi-conductrices de l'empilement 2 peuvent comporter chacune un matériau choisi parmi les matériaux III-V et II-VI. L'empilement 2 de couches semi-conductrices présente une épaisseur, notamment donnée par la somme des épaisseurs des couches semi-conductrices empilées dudit empilement 2. Les première et deuxième faces 3, 4 sont opposées selon l'épaisseur de l'empilement 2, c'est-à-dire qu'elles sont orientées vers des directions opposées, et notamment formées au moins en partie dans des plans parallèles entre eux et orthogonaux à la direction d'empilement des couches semi-conductrices de l'empilement 2 parallèle à l'axe Z. La direction d'empilement des couches semi-conductrices de l'empilement 2 est orthogonale aux plans des couches semi-conductrices de l'empilement 2. Autrement dit, les couches semi-conductrices de l'empilement 2 sont empilées entre les première et deuxième faces 3, 4. La diode électroluminescente 1 comporte aussi la première électrode 5 comportant une face 5a en contact avec la première face 3 de l'empilement 2, et la deuxième électrode 6 en contact avec l'empilement 2.

La première électrode 5 peut être une anode, ou une cathode, et la deuxième électrode 6 de type opposé à la première électrode 5 peut être une cathode, ou une anode. Les première et deuxième électrodes 5, 6 peuvent être métalliques, et présenter chacune une épaisseur comprise entre quelques nanomètres et 5 $\mu$m. Par exemple, les première et deuxième électrodes 5, 6 peuvent comporter au moins un matériau choisi parmi le nickel, l'argent, le platine, le titane, l'aluminium et l'or. Les première et deuxième électrodes 5, 6 peuvent être formées par des multicouches de matériaux conducteurs électriquement dont la résistivité est préférentiellement inférieure à $10^{-3}$ Ohms-centimètre. Notamment, chacune des première et deuxième électrodes 5, 6 présente une conductivité électrique supérieure à celle de la couche semi-conductrice de l'empilement 2 avec laquelle elle est en contact, par exemple d'un facteur 10, 100 ou 1000.

Classiquement, l'anode permet d'injecter des trous dans l'empilement 2 et la cathode permet d'injecter des électrons dans l'empilement 2. En ce sens, la face 5a de la première électrode 5 en contact avec la première face 3 est aussi appelée, le cas échéant, face d'injection de trous ou face d'injection d'électrons. La face 5a est orientée vers la région active 8 de l'empilement 2. En particulier, la face d'injection 5a de la première électrode 5 est parallèle à la première face 3, et est orthogonale à la direction d'empilement.

De manière préférée (figure 1), l'empilement 2 comporte une couche 9 en matériau semi-conducteur dopé de premier type (notamment en contact avec la deuxième électrode 6) et une couche 7 en matériau semi-conducteur dopé de second type (notamment en contact avec la première électrode 5). Le premier type et le second type sont opposés, et sont choisis parmi N et P. Lorsque le dopage est de type P, la couche dopée P est en contact avec l'anode qui injecte des trous dans ladite couche en matériau semi-conducteur dopé de type P lorsque la diode électroluminescente 1 est en fonctionnement. Lorsque le dopage est de type N, la couche dopée N est en contact avec la cathode qui injecte des électrons dans ladite couche en matériau semi-conducteur dopé de type N lorsque la diode électroluminescente 1 est en fonctionnement. La couche 9 en matériau semi-conducteur dopé de premier type et la couche 7 en matériau semi-conducteur dopé de second type sont des couches de transport de porteurs de charge, le cas échéant de trous si le dopage est de type P, ou d'électrons si le dopage est de type N. L'empilement 2 comporte aussi la région active 8 au sein de laquelle la recombinaison de porteurs de charge en vue de générer des photons est possible. Un porteur de charge peut être un électron ou un trou. La région active 8 est apte à générer des photons. En particulier, la région active 8 est agencée/située entre la couche 7 en matériau semi-conducteur dopé de second type et la couche 9 en matériau semi-conducteur dopé de premier type. La région active 8 peut être une région intercalaire située entre la couche en matériau dopé N et la couche en matériau dopé P. La région active 8 peut aussi être la simple jonction des couches en matériau semi-conducteur dopé de premier type et en matériau semi-conducteur dopé de second type (jonction PN), ou peut être une couche de l'empilement 2 pouvant comporter une seule couche (jonction PIN pour dopé P Intrinsèque dopé N) semi-conductrice ou une pluralité de couches semi-conductrices comme il le sera vu par la suite. La région active 8 peut être en contact avec la couche 9 en matériau semi-conducteur dopé de premier type, et en contact avec la couche 7 en matériau semi-conducteur dopé de second type. L'épaisseur de la région active 8 peut être adaptée par l'homme du métier en fonction des besoins. Selon une variante, l'empilement 2 peut comporter une couche de blocage 10 de porteurs de charge en matériau semi-conducteur agencée entre la région active 8 et la couche 7 en matériau semi-conducteur dopé de second type. Dans ce cas, la couche de blocage 10 est en contact avec la couche 7 en matériau semi-conducteur dopé de second type et la région active 8, et peut bloquer les électrons si le second type est de type P, ou bloquer les trous si le second type est de type N.

Selon un premier exemple, le matériau des couches 7, 9 en matériau semi-conducteur dopé de premier type et en matériau semi-conducteur dopé de second type peut comporter - ou être à base d'- un matériau semi-conducteur comme par exemple le nitrure de gallium (GaN). Dans ce premier exemple, le second type est le type P, et la couche 7 en matériau semi-conducteur dopé de second type peut comporter du nitrure de galium dopé par du magnésium. Dans ce premier exemple, le premier type est N, et la couche 9 en matériau semi-conducteur dopé de premier type peut comporter du nitrure de gallium dopé par du silicium. Selon ce premier exemple, la première électrode 5 est l'anode.

Selon un deuxième exemple, le matériau des couches 7, 9 en matériau semi-conducteur dopé de premier type et en matériau semi-conducteur dopé de second type peut comporter - ou être à base d'- un matériau semi-conducteur comme par exemple le phosphure d'indium (InP). Dans ce deuxième exemple, le second type est le type N, et la couche 7 en matériau semi-conducteur dopé de second type peut comporter du phosphure d'indium dopé par du soufre ou de l'étain. Dans ce deuxième exemple, le premier type est P, et la couche 9 en matériau semi-conducteur dopé de premier type peut comporter du phosphure d'indium dopé par du zinc. Selon ce deuxième exemple, la deuxième électrode 6 est l'anode.

Dans la présente description, lorsque l'on parle d'un dopage, il s'agit d'un dopage électrique : des impuretés ont été ajoutées à une substance pure ou souhaitée pure (dans l'exemple le GaN ou l'InP) afin de modifier intentionnellement ses propriétés de conductivité électrique.

De manière générale, toujours illustrée en figure 1, un évidement 11 est formé dans la deuxième face 4 de l'empilement 2 d'où il résulte que l'empilement 2 comporte une partie amincie 12. L'évidement 11 est notamment tel qu'il est formé dans une des couches semi-conductrices de l'empilement 2 de sorte à présenter une profondeur strictement inférieure à l'épaisseur maximale de ladite couche dans laquelle il est formé, l'évidement 11 peut alors être formé par un amincissement localisé d'une des couches semi-conductrices de l'empilement 2. L'évidement 11 est, selon la présente invention, formé dans la couche 9 en matériau semi-conducteur dopé de premier type qui présente une conductivité électrique strictement supérieure à la conductivité électrique de la couche 7 en matériau semi-conducteur dopé de second type : ceci permet de diminuer localement l'épaisseur de l'empilement en vue d'assurer une distribution convenable du courant lors du fonctionnement de la diode électroluminescente. Notamment, l'évidement 11 est formé de telle sorte qu'il reste une partie de la couche 9 en matériau semi-conducteur dopé de premier type entre un fond de l'évidement 11 et la région active 8. Ainsi, la partie amincie 12 de l'empilement 2 peut être telle qu'elle comporte une portion de chacune des couches semi-conductrices de l'empilement 2. Cette partie amincie 12 de l'empilement 2 s'étend donc de l'évidement 11 jusqu'à la première face 3. On dit alors que l'empilement 2 comporte l'évidement 11. Ainsi, l'évidement 11 peut être délimité par une ouverture 11a de l'évidement formée/ménagée dans la deuxième face 4, le fond 11b de l'évidement 11 et une paroi 11c de l'évidement 11 reliant le fond 11b à l'ouverture 11a. Le fond 11b et la paroi 11c peuvent correspondre à des surfaces de la couche 9 en matériau semi-conducteur dopé de premier type. Le fond 11b peut être plat. La paroi 11c s'étend notamment depuis le fond 11b pour, par exemple, former un cylindre droit creux. On dit notamment que l'évidement 11 est un trou non débouchant, c'est-à-dire un trou borgne, formé dans la deuxième face 4 en particulier dans la couche 9 en matériau semi-conducteur dopé de premier type (figure 2). C'est en ce sens que la figure 2 illustre schématiquement la diode électroluminescente 1 comportant l'évidement 11, dont la paroi 11c reliant le fond 11b à l'ouverture 11a de l'évidement comporte quatre flancs perpendiculaires au fond 11b et perpendiculaires entre eux deux à deux de sorte à former un cadre. L'évidement 11 au sens de la présente description n'est pas une simple rugosité de surface.

Selon une réalisation, par exemple illustrée en figure 1, l'évidement 11 délimite ladite partie amincie 12 avec une partie 13 de la première face 3. Dans ce cas, la partie 13 de la première face 3 présente une aire strictement inférieure à l'aire de la première face 3. En particulier, on dit que l'évidement 11 permet de délimiter un côté de la partie amincie de l'empilement 2, et que la partie 13 de la première face 3 délimite un autre côté de la partie amincie de l'empilement 2. Selon une autre formulation, la partie amincie s'étend depuis la partie 13 de la première face 3 jusqu'à l'évidement 11. La partie amincie 12 de l'empilement 2 permet de former une cavité optique de l'empilement 2 adaptée à une longueur d'onde d'émission principale de la diode électroluminescente 1. Notamment, on dit que la partie amincie 12 de l'empilement 2 comporte la première partie 13 de la première face 3 et une surface de l'empilement 2 participant à délimiter l'évidement 11. En particulier, la première face 3, ou au moins la partie 13 de la première face 3 est plane, et pour tout point de la partie 13 de la première face 3, il existe une droite passant par ledit point et perpendiculaire à la partie 13 de la première face 3 telle que ladite droite passe par l'évidement 11. De préférence, tout point de la première électrode 5 peut être projeté orthogonalement dans un plan orthogonal à la direction d'empilement des couches semi-conductrices de l'empilement 2 et passant par l'évidement 11, notamment passant par l'ouverture 11a de l'évidement 11 de sorte que tous les points projetés de la première électrode 5 le soit dans une zone du plan inclue dans l'évidement 11 pour favoriser la recombinaison de porteurs de charge au sein de la partie amincie 12.

L'amincissement de l'empilement 2 permet d'exacerber les interférences constructives décrites ci-avant en vue d'améliorer l'émission de photons par la diode électroluminescente 1, notamment depuis le sommet de la partie amincie 12 de l'empilement opposé à la première face 3. Ainsi, la surface d'émission de la diode électroluminescente 1 est notamment formée par la surface de l'empilement 2 (ou au moins une partie de cette surface de l'empilement 2) participant à délimiter l'évidement 11. La face d'émission de la diode électroluminescente 2 est donc du côté de la deuxième face 4.

La face 5a de la première électrode 5 en contact avec la première face 3 de l'empilement 2 est en contact uniquement avec la partie amincie 12 de l'empilement 2. Sur la figure 1, la face 5a de la première électrode 5 est en contact uniquement avec la partie 13 de la première face 3. Ceci permet de localiser la recombinaison des porteurs de charge (trous et électrons) dans la partie amincie 12 de l'empilement 2, c'est-à-dire dans au moins une partie de la région active 8 située dans la partie amincie 12, lorsque la diode électroluminescente est en fonctionnement.

De préférence, la face 5a de la première électrode 5 en contact uniquement avec la partie amincie 12 de l'empilement 2, et donc le cas échéant uniquement avec la partie 13 de la première face 3, présente une aire inférieure ou égale à l'aire de ladite partie 13 de la première face 3. Ceci permet une meilleure efficacité de la diode électroluminescente 1 dans le sens où la couche 7 en matériau semi-conducteur dopé de second type présente une conductivité telle que les lignes de courant en son sein sont généralement verticales, c'est-à-dire parallèles à la direction d'empilement des couches semi-conductrices de l'empilement 2. On va ainsi concentrer les probabilités de recombinaison des porteurs de charge dans la partie amincie 12 de l'empilement 2, notamment au sein d'une partie 8a (figure 1) de la région active 8 située dans la partie amincie 12 de l'empilement 2. En fait, c'est au sein de la partie 8a de la région active 8 que la majorité des porteurs de charge se recombinent. On comprend alors que seule une partie négligeable des porteurs de charge peut se recombiner dans la région active 8 hors de la partie amincie 12 de l'empilement 2. Le fait que l'aire de la partie 13 de la première face 3 soit inférieure à l'aire de la première face 3 permet par exemple d'éviter un problème, notamment lié au « quenching », en cas d'une gravure de la couche 7 en matériau semi-conducteur dopé de second type.

La figure 3 est une version simplifiée de la figure 1 pour laquelle les hachures ont été retirées pour faire apparaitre les lignes de courant (flèches F1) dans la couche 7 en matériau semi-conducteur dopé de second type entre la première électrode 5 et la région active 8. Dans le domaine, on dit généralement que l'ombre de la première électrode 5 dans la région active 8 caractérise la région majoritaire de recombinaison des porteurs de charge. L'ombre de la première électrode 5 dans la région active 8 est notamment telle que chaque point de la région active 8 ombrée par la première électrode 5 peut être projeté orthogonalement sur la face 5a de la première électrode 5.

Par ailleurs, la deuxième électrode 6 est en contact avec une zone de l'empilement 2 distincte de ladite partie amincie 12 de l'empilement 2 (figure 1). Ainsi, la deuxième électrode 6 n'est notamment pas en contact avec la partie amincie 12, la deuxième électrode 6 peut alors être à distance de la partie amincie 12. Cette zone de l'empilement 2 correspond notamment à une surface extérieure de l'empilement 2. Ceci permet, d'une part, d'autoriser l'émission de photons depuis la partie amincie 12 de l'empilement 2 du côté de la deuxième face 4 sans que la deuxième électrode 6 ne gêne cette émission par le sommet de la partie amincie 12, et, d'autre part, d'améliorer la distribution du courant dans la diode électroluminescente 1 en augmentant la longueur de dispersion du courant (« spreading length » en langue anglaise) de la diode électroluminescente 1. La figure 3 permet justement d'illustrer les lignes de courant (flèches F2), provenant de la deuxième électrode 6 disposée sur la deuxième face 4 de la diode électroluminescente 1, qui traversent la couche 9 en matériau semi-conducteur dopé de premier type. Ces lignes présentent un allongement plus important que si la deuxième électrode 6 était en contact avec la partie amincie 12. Ainsi, le positionnement des première et deuxième électrodes 5, 6 par rapport à la partie amincie 12 permet d'augmenter l'efficacité d'extraction de la LED (plus de photons pourront s'échapper de la diode électroluminescente par la combinaison de la partie amincie avec le positionnement adapté des première et deuxième électrodes).

De préférence, comme illustré en figures 1 à 4, la deuxième électrode 6 est disposée, c'est-à-dire formée, sur la deuxième face 4, notamment à la périphérie de l'ouverture 11a de l'évidement 11. La deuxième électrode 6 peut, par exemple, adopter la forme d'une piste électriquement conductrice fermée. Avec cet agencement, la deuxième électrode 6 est notamment située à distance de la surface d'émission de l'empilement, ou la deuxième électrode 6 et la surface d'émission sont agencées de sorte qu'il existe un contact, ou une interface, entre la deuxième électrode 6 et un contour périphérique de la surface d'émission. Sur la figure 1, la deuxième électrode 6 est positionnée sur une zone de l'empilement 2 associée à une partie de l'empilement 2 qui n'est pas amincie de manière à ce que le courant émanant de la deuxième électrode 6 puisse se distribuer uniformément dans la partie 8a de région active 8 située dans la partie amincie 12 de l'empilement 2. La deuxième électrode 6 s'étend notamment sur la deuxième face 4 depuis un contour de l'ouverture 11a de l'évidement 11.

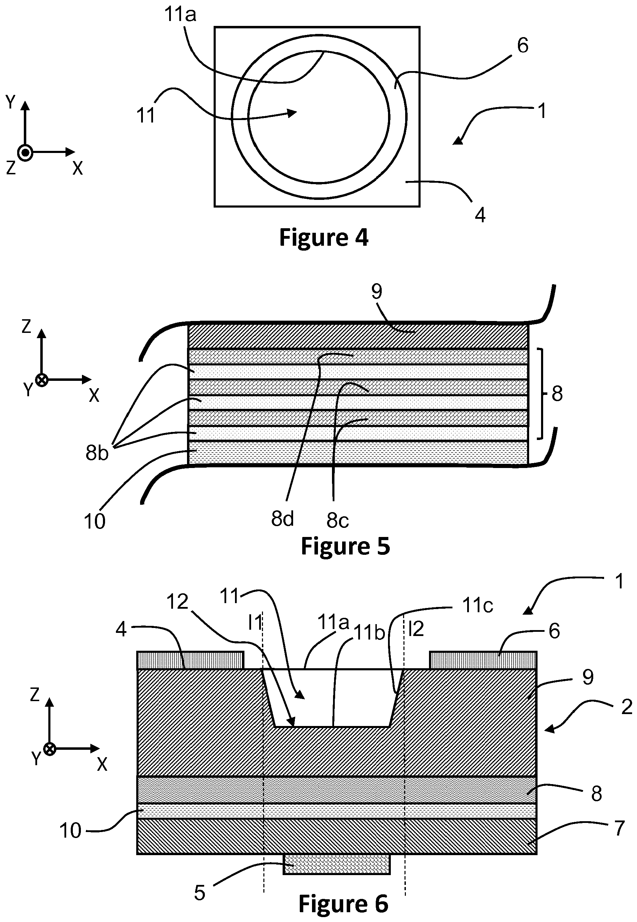

De préférence, la diode électroluminescente 1 présente une longueur de dispersion du courant et, orthogonalement à la direction d'empilement des couches semi-conductrices de l'empilement 2, l'évidement 11 présente une dimension $d_{ev}$ (visible en figure 1), par exemple un diamètre (figure 4) ou une largeur, compris(e) entre une fois et cinq fois la longueur de dispersion du courant de la diode électroluminescente 1. Cette dimension est notamment celle séparant deux flancs en regard l'un de l'autre de la paroi 11c de l'évidement 11 (figure 1), en particulier lorsque la paroi 11c de l'évidement comporte quatre flancs reliés deux à deux à la manière de ce qui est illustré en figure 2. Le choix d'une telle dimension permet de limiter les pertes de courant au centre de la diode électroluminescente 1 du fait que le courant décroit selon un paramètre d'exponentielle divisé par la longueur de dispersion du courant de la diode électroluminescente 1. En ce sens, la dimension visée ici est notamment une dimension maximale comprise entre une fois et cinq fois la longueur de dispersion du courant de la diode électroluminescente 1. Ceci est notamment valable lorsque la deuxième électrode 6 est disposée sur la deuxième face 4 à la périphérie de l'ouverture 11a de l'évidement 11. De manière générale, les dimensions de l'évidement 11 dépendantes de la longueur de dispersion du courant données ci-dessus sont notamment valables lorsque le fond 11b de l'évidement 11 est situé entre deux plans, notamment parallèles, passant respectivement par la première électrode 5 (notamment par la face 5a de la première électrode 5) et la deuxième électrode 6 (notamment par une face de la deuxième électrode 6 en contact avec l'empilement 2), ou selon une autre formulation lorsque le fond 11b se situe à un niveau situé entre la première électrode 5 et la deuxième électrode 6. Ainsi, un plan, passant par le fond 11b de l'évidement 11 et orthogonal à la direction d'empilement des couches semi-conductrices de l'empilement 2, peut être situé entre les première et deuxième électrodes 5, 6, ce plan étant situé à distance des première et deuxième électrodes 5, 6.

La longueur de dispersion du courant de la diode électroluminescente 1 est une notion connue de l'homme du métier. A titre d'exemple, la longueur de dispersion $L_s$ du courant de la diode électroluminescente 1 peut être calculée de la manière suivante :

$$L_s = (r_c + \rho_{t1} \times t_{t1} + \rho_{t2} \times t_{t2})^{1/2} \times \left| \frac{\rho_{t1}}{t_{t1}} - \frac{\rho_e}{t_e} \right|^{-1/2}$$

avec $\rho_{t1}$ la résistivité de la couche 9 en matériau semi-conducteur dopé de premier type, $\rho_e$ la résistivité de la première électrode 5, $t_{t1}$ l'épaisseur maximale de la couche 9 en matériau semi-conducteur dopé de premier type, $t_e$ l'épaisseur de la première électrode 5, $r_c$ correspondant à la somme des résistances de contact entre les différents matériaux de la diode électroluminescente 1, $\rho_{t2}$ correspondant à la résistivité de la couche 7 en matériau semi-conducteur dopé de second type, $t_{t2}$ correspondant à l'épaisseur de la couche 7 en matériau semi-conducteur dopé de second type. Dans la formule donnant $L_s$, « $\times$ » représente la multiplication.

On comprend de ce qui a été décrit précédemment que l'épaisseur de la partie amincie 12 de l'empilement 2 peut être choisie pour, lorsque la diode électroluminescente 1 est en fonctionnement, favoriser les interférences constructives entre les ondes électromagnétiques directes et les ondes électromagnétiques réfléchies émises depuis la région active 8 de l'empilement 2, et favoriser les interférences liées à la cavité optique de l'empilement 2 incluse dans la partie amincie 12. Pour cela, l'empilement 2 présente préférentiellement une première épaisseur d1 (figure 1) entre ses première et deuxième faces 3, 4 dite épaisseur maximale de l'empilement, et une deuxième épaisseur d (figure 1) entre le fond 11b de l'évidement 11 et la première face 3. Bien entendu, la deuxième épaisseur $d$ est strictement inférieure à la première épaisseur. La deuxième épaisseur d satisfait l'équation suivante :

$$d = z + L$$

avec $z = k_z \cdot \frac{\lambda}{2n}$, $d = k_d \cdot \frac{\lambda}{2n}$, et L étant tel que $\frac{\lambda}{2n} \cdot (k_d - k_z) = L$, avec $k_d > k_z$, $k_d$ et $k_z$ étant des entiers positifs non nuls (c'est-à-dire différents de 0), $\lambda$ étant la longueur d'onde d'émission principale en fonctionnement de la diode électroluminescente, et n un indice optique de l'empilement 2 déterminé à la longueur d'onde d'émission principale. Ici, ". " représente l'opérateur multiplication dans les équations. Notamment, l'indice optique n peut être celui du matériau qui entre majoritairement dans la composition des couches de transport, c'est-à-dire des couches 7, 9 en matériau semi-conducteur dopé de premier type et en matériau semi-conducteur de second type. Ainsi, le cas échéant, n peut être égal à l'indice optique du GaN ou de l'InP. Alternativement, l'indice optique n peut être un indice optique moyen, déterminé à la longueur d'onde d'émission principale, de semi-conducteurs utilisés dans l'empilement 2. L'indice optique est aussi connu sous la dénomination « indice de réfraction », et correspond à la racine carrée de la constante diélectrique du matériau considéré à la fréquence optique (la longueur d'onde) considérée.

De préférence, $k_z$ est strictement supérieur à 1 et strictement inférieur à 6. En effet, pour une valeur de $k_z$ en dessous de 2, la première électrode 5 serait trop proche de la région active 8, ce qui augmenterait la probabilité de « quenching » en langue anglaise (extinction de luminescence en langue française) c'est-à-dire notamment qu'un exciton puisse se recombiner non radiativement dans le continuum de niveau de la première électrode 5. Avec une valeur de $k_z$ supérieure ou égale à 6, la couche 7 en matériau semi-conducteur dopé de second type deviendrait trop épaisse, ce qui aurait pour conséquence d'induire, d'une part, des pertes ohmiques liées au transport de porteurs de charge par la couche 7 en matériau semi-conducteur dopé de second type, et, d'autre part, une augmentation de l'absorption optique car les couches semi-conductrices n'ont pas une absorption nulle (en particulier GaN dopé P dont la maille est fortement altéré par l'introduction massive de dopant Mg), et donc d'altérer le fonctionnement de la diode électroluminescente 1. De préférence, $k_z$ est tel que la couche 7 en matériau semi-conducteur dopé de second type présente, au sein de la partie amincie 12 de l'empilement 2, une épaisseur supérieure ou égale à 50nm et de préférence strictement inférieure à 200nm. Par ailleurs, de préférence $k_d$ est strictement inférieur à 10, ceci s'explique par le fait que l'on souhaite minimiser l'absorption optique au sein de la diode électroluminescente. De plus, $k_d$ est tel que la couche 9 en matériau dopé semi-conducteur de premier type présente, entre le fond 11b de l'évidement 11 et une face de la couche 9 en matériau semi-conducteur dopé de premier type orientée vers la couche 7 en matériau semi-conducteur dopé de second type, une épaisseur supérieure ou égale à 100nm. En cas d'ambiguïté sur le choix de $k_d$, il est préférable d'opter pour la valeur la plus faible parmi celles présélectionnées selon les critères explicités ci-avant pour limiter l'absorption optique. Autrement dit, on fixe $k_z$ à la valeur la plus petite permettant d'obtenir au moins 50nm d'épaisseur pour la couche en matériau semi-conducteur dopé de deuxième type, et on fixe $k_d$ à la valeur la plus petite permettant d'obtenir une épaisseur minimale de 100nm de la couche 9 en matériau semi-conducteur dopé de premier type dans la partie amincie de l'empilement.

On comprend donc que les choix de valeur pour $k_z$ et $k_d$ ont une influence sur l'épaisseur de la couche 7 en matériau semi-conducteur dopé de second type, et sur l'épaisseur de la couche 9 en matériau semi-conducteur dopé de premier type entre la région active 8 et le fond 11b de l'évidement. Pour visualiser l'influence de l'épaisseur des couches en matériau semi-conducteur dopé de second type et en matériau semi-conducteur dopé de premier type, il est possible d'établir par simulation une cartographie de la radiance (ou luminance énergétique) dont l'unité est le watt par mètre carré par stéradian ($W.m^{-2}.sr^{-1}$) donnée en fonction de l'épaisseur de la couche 7 en matériau semi-conducteur dopé de second type et en fonction de l'épaisseur de la couche 9 en matériau semi-conducteur dopé de premier type. Une telle simulation est associée à une région active 8 dont la structure est fixée, et le cas échéant à une couche de blocage de porteurs de charge interposée entre la couche 7 en matériau semi-conducteur dopé de second type et la région active 8 dont les caractéristiques sont aussi fixées. Avec une telle cartographie, il est possible de remarquer des couples de valeur d'épaisseur pour lesquels la radiance atteint des valeurs optimisées. On constate aussi que le choix d'un couple de valeurs $k_z$ et $k_d$, selon les contraintes de choix données précédemment, correspond à un couple de valeurs d'épaisseur adapté des couches 7, 9 en matériau semi-conducteur dopé de second type et en matériau semi-conducteur dopé de premier type.

Notamment (figure 1), la partie amincie 12 de l'empilement 2 comporte une première partie reliant la première électrode 5 à une zone (aussi appelée zone interne de l'empilement 2) située dans la région active 8 de l'empilement 2. La première partie présente une épaisseur égale à *z* obtenue selon les calculs évoqués ci-dessus. La première partie comporte notamment une portion de la couche 7 en matériau semi-conducteur dopé de second type. La partie amincie 12 comporte aussi une deuxième partie s'étendant de la première partie jusqu'au fond 11b de l'évidement 11, la deuxième partie présente une épaisseur égale à *L* obtenue selon les calculs évoqués ci-dessus.

En particulier, comme illustré en figure 1, la première partie de la partie amincie 12 de l'empilement 2 comporte au moins une portion 70 de la couche 7 en matériau semi-conducteur dopé de second type dont l'épaisseur correspond à l'épaisseur de la couche 7 en matériau semi-conducteur dopé de second type au sein de la partie amincie 12. La première partie de la partie amincie 12 de l'empilement 2 peut aussi, le cas échéant, comporter une portion 100 de la couche de blocage de porteurs de charge 10 dont l'épaisseur correspond à l'épaisseur de la couche de blocage de porteurs de charge 10 au sein de la partie amincie 12. La première partie de la partie amincie 12 de l'empilement 2 peut aussi comporter une portion 80a de la région active 8 dont l'épaisseur est strictement inférieure à l'épaisseur de la région active 8 au sein de la partie amincie 12.

En particulier, comme illustré en figure 1, la deuxième partie de la partie amincie 12 comporte selon son épaisseur au moins une portion 90 de la couche 9 en matériau semi-conducteur dopé de premier type, l'épaisseur de la portion 90 de la couche 9 en matériau semi-conducteur dopé de premier type correspondant à la distance séparant la face de la couche 9 en matériau semi-conducteur dopé de premier type orientée vers la région active 8 (ou vers la couche 7 en matériau semi-conducteur dopé de second type) du fond 11b de l'évidement 11. Par ailleurs, la deuxième partie de la partie amincie 12 de l'empilement 2 peut aussi comporter une portion 80b de la région émissive 8 distincte de la portion 80a de la région émissive 8 que comporte la première partie.

La région active 8 peut être formée par une jonction PN, ou en une seule couche (jonction PIN), ou peut comporter une pluralité de couches actives formant chacune un puits quantique et séparées deux à deux par une couche barrière (« cladding layer » en anglais). La structure de la région active 8 dépend de la longueur d'onde d'émission principale souhaitée pour la diode électroluminescente 1, la réalisation d'une région active 8 est bien connue de l'homme du métier. Selon une réalisation, la région active 8 comporte plusieurs couches actives 8b (Figure 5) - qui appartiennent donc à l'empilement de couches semi-conductrices - permettant chacune la recombinaison de porteurs de charge au moins dans la partie de la région active 8 située dans la partie amincie de l'empilement. Chaque couche active 8b peut former un puits quantique. Les couches actives 8b adjacentes peuvent être séparées par une couche barrière 8c adaptée aux couches actives qu'elle sépare. La couche active 8b la plus proche de la couche 9 en matériau semi-conducteur dopé de premier type, peut être reliée à ladite couche 9 en matériau semi-conducteur dopé de premier type par une couche barrière additionnelle 8d. La couche active 8b la plus proche de la première électrode peut être en contact soit avec la couche de blocage 10 si elle est présente, soit avec une couche barrière correspondante. Chaque couche active 8b peut présenter une épaisseur comprise entre 1 nm et 8 nm, chaque couche barrière peut présenter une épaisseur comprise entre 3 nm et 15 nm. Une couche active peut être en nitrure de gallium, en nitrure d'aluminium-gallium, ou en nitrure de gallium indium dont les pourcentages atomiques des composés peuvent être adaptés en fonction des matériaux utilisés dans les couches de transports ou les couches barrières. Les couches barrières peuvent être : en $In_xGa_{1-x}N$ si le puits quantique est en $In_yGa_{1-y}N$ avec x<y et x pouvant être égal à 0, ou en $Al_xGa_{1-x}N$ si le puits quantique est en $Al_yGa_{1-y}N$ avec x>y et y pouvant être égal à 0.

Dans l'exemple où la région active 8 comporte plusieurs couches actives permettant chacune la recombinaison de porteurs de charge, la zone située dans la région active 8 est située dans la couche active 8b permettant la recombinaison de porteurs de charge la plus proche de la première électrode 5. Ceci permet en correspondance avec les valeurs de *z* et *L* d'optimiser l'épaisseur de la partie amincie. En ce sens, la zone située dans la région active 8 est préférentiellement située dans un plan médian, orthogonal à la direction selon laquelle l'épaisseur de la couche active est mesurée, de ladite couche active 8b la plus proche de la première électrode 5.

Selon une mise en œuvre particulière dans laquelle la région active 8 comporte une pluralité de couches actives formant chacune un puits quantique, la source d'émission des photons n'est pas localisée en un point, ni en un plan mais au contraire dans plusieurs puits, c'est-à-dire plusieurs plans agencés dans la région active 8 de l'empilement 2. Pour optimiser une telle structure de diode électroluminescente, il serait par exemple possible de prendre en compte les différentes couches formant les puits quantiques comme des sources ponctuelles indépendantes. Ensuite, il faudrait sommer les résultats pour optimiser l'épaisseur de la cavité optique, c'est-à-dire de l'empilement de couches entre la première électrode et le fond de l'évidement, en jouant sur l'épaisseur de la portion de la couche en matériau semi-conducteur dopé de second type présente dans la partie amincie de l'empilement, et sur l'épaisseur de la portion de la couche en matériau semi-conducteur dopé du premier type présente dans la partie amincie de l'empilement.

Cependant, en particulier dans le cas d'une LED à base de GaN, InGaN ou AlGaN, la première électrode 5 est une anode, et le raisonnement relatif aux sources ponctuelles indépendantes peut se simplifier de la manière suivante : la mobilité des électrons étant supérieure à celle des trous, la majorité des recombinaisons au sein de la région active 8 aura lieu dans la couche formant le puits quantique la plus proche de la première électrode 5. C'est en ce sens que la première partie de la partie amincie 12 de l'empilement 2 s'étend préférentiellement depuis la partie 13 de la première face 3 jusqu'à la zone située dans la région active 8 évoquée précédemment. Ladite zone située dans la région active 8 est alors située préférentiellement à la médiane de la couche, selon son épaisseur, formant le puits quantique la plus proche de la première électrode 5. On dit alors que la première partie de la partie amincie de l'empilement 2 comporte la portion de la couche 7 en matériau semi-conducteur dopé de second type et une tranche/portion de la couche formant puits quantique la plus proche de l'anode 5. Dans le cas particulier d'une LED à base d'InP, ce sont les trous qui sont plus mobiles que les électrons, c'est pour cela que le raisonnement ci-dessus s'inverse en considérant que la première électrode est une cathode.

Selon une réalisation, la forme de l'évidement 11 peut aussi contribuer à l'amélioration de l'efficacité de la diode électroluminescente 1 en tenant compte de la longueur de dispersion du courant de la diode électroluminescente 1.

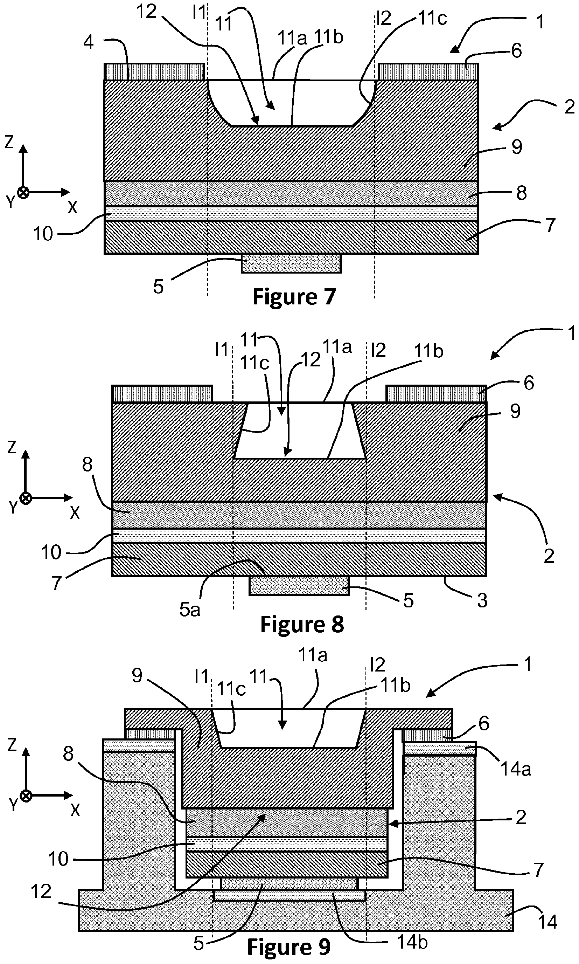

Sur la figure 1, les flancs d'une gravure délimitant l'amincissement de la couche 9 en matériau semi-conducteur dopé de premier type sont représentés avec des angles droits par rapport au fond 11b. Cependant, il ne s'agit pas d'une caractéristique essentielle de l'invention puisque la paroi 11c de l'évidement 11 peut être formée par des flancs de préférence en biais, formant alors un trapèze (figure 6) dont la plus petite base est proximale de la région active 8 et de sorte que l'aire du fond 11b de l'évidement 11 soit strictement inférieure à l'aire de l'ouverture 11a de l'évidement 11 : avec un tel agencement, la distribution du courant est facilitée, notamment lorsque la deuxième électrode 6 est formée sur la deuxième face 4. Cependant, il peut aussi être imaginé une paroi 11c comprenant un ou des flancs concaves (figure 7) ou convexes, ou une paroi 11c dont les flancs sont en biais (figure 8) pour former un rétrécissement de l'évidement 11 à l'ouverture 11a de l'évidement 11 au sommet de la diode électroluminescente 1 de sorte à former un diaphragme limitant le cône d'émission de la diode électroluminescente 1.

La figure 8 représente une mise en œuvre selon laquelle l'ouverture 11a de l'évidement présente des dimensions inférieures aux dimensions de l'évidement 11 mesurées dans un plan situé entre l'ouverture 11a de l'évidement et le fond 11b de l'évidement 11, ce plan étant notamment parallèle aux plans des couches de l'empilement 2. Selon une autre formulation, l'aire du fond 11b est ici strictement supérieure à l'aire de l'ouverture 11a de l'évidement. Ici les photons devront préférentiellement passer au travers de l'ouverture 11a de l'évidement 11. En ce sens, l'ouverture 11a de l'évidement 11 présente une aire supérieure ou égale à l'aire de ladite face 5a de la première électrode 5 en contact avec la première face 3 de l'empilement. Ici de préférence, la face 5a la première électrode 5 est orientée vers l'ouverture 11a de l'évidement 11, on dit notamment que l'ouverture 11a de l'évidement est située au-dessus, ou à l'aplomb, de la première électrode 5 alors située en partie basse de la diode électroluminescente 1. En ce sens, la face 5a de la première électrode 5 étant plane, tout point de la face 5a de la première électrode 5 orientée vers la région active 8 peut être associé à une droite passant par ce point et orthogonal à ladite face 5a de la première électrode 5, ladite droite traversant l'ouverture 11a de l'évidement 11. Ceci permet d'améliorer la distribution du courant au sein de la diode électroluminescente 1 pour l'application souhaitée. Par ailleurs, une telle mise en œuvre permet de contrôler le faisceau émis par la diode électroluminescente 1 du côté où se situe la deuxième électrode 6.

Pour optimiser la distribution spatiale du courant lors du fonctionnement de la diode électroluminescente 1, de préférence lorsque la deuxième électrode 6 est disposée/formée sur la deuxième face 4 (figure 7), la paroi 11c de l'évidement 11 reliant le fond 11b de l'évidement à l'ouverture 11a de l'évidement 11 est telle qu'elle comporte un contour reliant un point de l'ouverture 11a de l'évidement 11 à un point du fond 11b de l'évidement 11. Ledit contour est notamment pris selon un plan de coupe orthogonal aux couches de l'empilement 2 et notamment au fond de l'évidement 11. La forme de ce contour est préférentiellement une exponentielle dépendante de la longueur de dispersion du courant de la diode électroluminescente 1. En particulier, cette forme prise dans un plan parallèle au plan ZX est du type

$$f(x) = 1.e^{\left(\frac{-x}{Ls}\right)}$$ pour la partie gauche de la paroi de l'évidement de la figure 7 et du type $$f(x) = 1.e^{\left(\frac{x}{Ls}\right)}$$ pour la partie droite de la paroi de l'évidement de la figure 7. Autrement dit, la paroi 11c de l'évidement 11 peut être concave, c'est-à-dire qu'elle peut comporter, selon un plan de coupe perpendiculaire au fond 11b de l'évidement 11, un contour concave, de préférence représentatif d'une fonction exponentielle dépendante de la longueur de dispersion du courant $L_s$ de la diode électroluminescente 1. Ce contour relie, dans le plan de coupe, un point de l'ouverture 11a de l'évidement 11 à un point du fond 11b de l'évidement 11. Selon une réalisation où l'ouverture de l'évidement est circulaire, la paroi de l'évidement peut être est délimitée par une surface de révolution obtenue par la rotation d'une courbe plane dont l'équation est représentative d'une exponentielle dépendante de la longueur de dispersion du courant de la diode électroluminescente. La rotation de la courbe plane se faisant autour d'un axe parallèle à l'axe Z et passant par le fond de l'évidement.

L'évidement 11 peut présenter une profondeur correspondant à une valeur comprise entre 2% et 98% de l'épaisseur maximale de la couche 9 en matériau semi-conducteur dopé de premier type. Notamment, selon l'exemple illustré en figures 1 et 6 à 8, l'épaisseur de la couche 9 en matériau semi-conducteur dopé de premier type entre la deuxième électrode 6 et la face de la couche 9 en matériau semi-conducteur dopé de premier type orientée vers la couche 7 en matériau semi-conducteur dopé de second type peut être comprise entre 1µm et 10µm. En dessous de 1µm la longueur de dispersion du courant de la diode électroluminescente imposera une première électrode 5 trop petite pour que la surface d'émission de la diode électroluminescente soit correcte, et au-dessus de 10µm le prix de la diode électroluminescente sera trop important. Pour le reste de l'empilement 2, les épaisseurs seront choisies en fonction de l'indice optique, de la longueur d'onde d'émission principale ainsi que des valeurs $k_d$ et $k_z$. De manière générale, on essayera de conserver une épaisseur maximale pour l'empilement 2 comprise entre 1µm et 800µm.

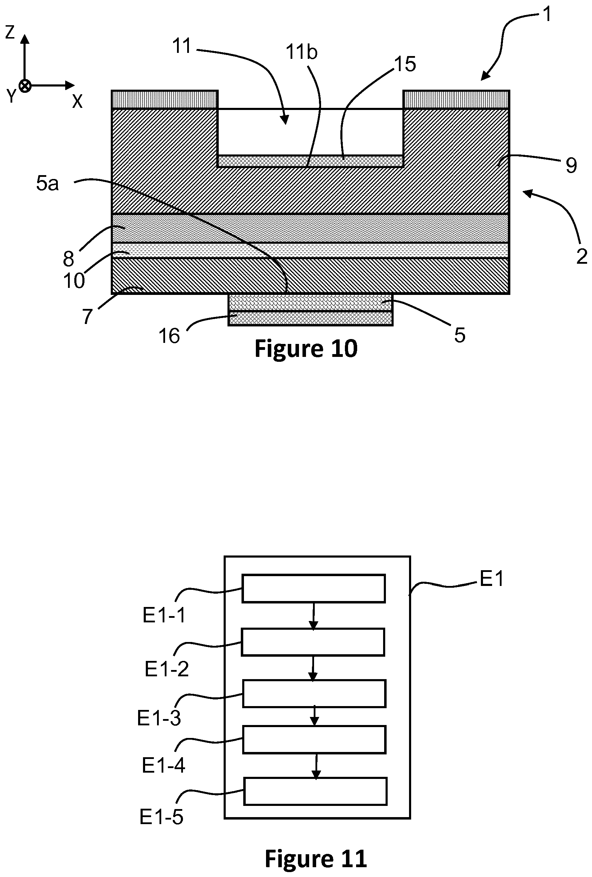

On comprend de ce qui a été décrit ci-dessus que l'invention est aussi relative à un procédé d'élaboration (figure 11) d'une diode électroluminescente 1 telle que décrite, c'est-à-dire que ladite diode électroluminescente 1 à élaborer comporte l'empilement de couches semi-conductrices comprenant la première face 3 et la deuxième face 4 opposées selon l'épaisseur de l'empilement 2. Le procédé d'élaboration est notamment mis en œuvre en vue d'ultérieurement fabriquer ladite diode électroluminescente telle qu'élaborée. Les avantages liés au procédé d'élaboration découlent de ceux décrits dans le cadre de la diode électroluminescente 1 en vue de la fabriquer pour qu'elle présente les avantages souhaités. La diode électroluminescente 1 à élaborer comporte aussi la première électrode 5 comportant la face 5a en contact avec la première face 3 de l'empilement 2, et la deuxième électrode 6. Dans ce cas, le procédé d'élaboration comporte une étape de conception E1 de l'empilement 2 dont la deuxième face 4 présente l'évidement (alors formé dans la deuxième face 4) pour former la partie amincie 12 de l'empilement 2. Cette étape de conception E1 prend en compte les caractéristiques suivantes :

- ladite face 5a de la première électrode 5 de la diode électroluminescente 1 est destinée à être en contact uniquement avec la partie amincie 12 de l'empilement 2,
- la deuxième électrode 6 de la diode électroluminescente 1 est destinée à être en contact avec une zone de l'empilement distincte de ladite partie amincie 12 de l'empilement 2.

On comprend que l'étape de conception E1 permet de mettre en œuvre l'élaboration de la diode électroluminescente 1.

En particulier, l'étape de conception E1 de l'empilement 2 comporte les étapes suivantes :

- une étape de détermination E1-1 de la longueur d'onde d'émission principale $\lambda$ de la diode électroluminescente lors de son fonctionnement,
- une étape de détermination E1-2, à la longueur d'onde d'émission principale, de l'indice optique n de l'empilement 2, notamment tel que décrit précédemment,
- une étape de détermination E1-3 de l'épaisseur d de la partie amincie 12 entre la première face 3 et le fond 11b de l'évidement 11, l'épaisseur d satisfaisant $d = z + L$ avec $z = k_z . \dfrac{\lambda}{2n}$ , $d = k_d . \dfrac{\lambda}{2n}$ et L étant tel que $\dfrac{\lambda}{2n} . (k_d - k_z) = L$ avec $k_d > k_z$, $k_d$ et $k_z$ étant des entiers positifs différents de 0.

Notamment, l'étape de détermination E1-3 de l'épaisseur d comporte une étape de choix de la valeur de $k_z$, $k_z$ devant être strictement supérieur à 1 et strictement inférieur à 6, et une étape de choix de la valeur $k_d$, $k_d$ devant être strictement inférieur à 10. Toutes les contraintes liées aux valeurs de $k_z$ et $k_d$ décrites en combinaison avec la diode électroluminescente peuvent s'appliquer au procédé d'élaboration.

Les étapes E1-1 à E1-3 permettent notamment de déterminer l'épaisseur maximale de l'empilement 2, et de déterminer les différentes couches semi-conductrices qui devront le composer.

Par ailleurs, l'étape de conception E1 de l'empilement 2 peut comporter une étape de détermination E1-4 de la longueur de dispersion du courant de la diode électroluminescente 1. L'étape de conception E1 comporte aussi une étape de dimensionnement E1-5 de l'évidement 11 de sorte que, orthogonalement à une direction d'empilement des couches semi-conductrices de l'empilement 2, ledit évidement 11 présente une dimension (par exemple un diamètre, une largeur), notamment maximale, comprise entre une fois et cinq fois la longueur de dispersion du courant de la diode électroluminescente 1.

En particulier, tout ce qui a été décrit dans le cadre de la diode électroluminescente 1 peut aussi s'appliquer dans le cadre du procédé d'élaboration. Dans ce cas, l'étape de conception E1 peut aussi prendre en compte le fait que l'empilement 2 devra comporter, pour sa partie amincie 12, les première et deuxième parties décrites ci-avant.

L'invention peut être aussi relative à un procédé de fabrication d'une diode électroluminescente 1 telle que décrite comprenant une étape d'élaboration de la diode électroluminescente 1 mettant en œuvre le procédé d'élaboration de la diode électroluminescente 1, et une étape de fabrication de la diode électroluminescente 1 selon les résultats de l'étape d'élaboration de la diode électroluminescente 1.

Il est donné ci-après un exemple particulier d'une diode électroluminescente dont l'empilement est à base de GaN, c'est-à-dire dont le matériau des couches en matériau dopé de premier type (dopage N) et de deuxième type (dopage P) est du GaN. Dans ce cas, l'indice optique n est égal à 2,49 pour une longueur d'onde d'émission principale de 450nm en fonctionnement de la diode électroluminescente. Dans cet empilement, il est agencé entre la couche en matériau semi-conducteur dopé de second type et la couche en matériau semi-conducteur dopé de premier type les couches successives suivantes : une couche de blocage d'électrons en AlGaN et au moins une couche formant un puits quantique d'épaisseur égale à 10nm en InGaN. Selon cet exemple, on a donc $\frac{\lambda}{2n} \sim 90nm$. Dans cet exemple, $z$ représente l'épaisseur de la première partie de la partie amincie de l'empilement, et correspond à la somme des épaisseurs de la couche en matériau semi-conducteur dopé de second type, de la couche de blocage d'électrons, et de la moitié de l'épaisseur du puits quantique le plus proche de la couche de blocage. Ainsi, pour une émission à longueur d'onde de 450nm, on optera en priorité à $k_z$=2 d'où z =90*2=180nm, c'est-à-dire une épaisseur de la couche en matériau dopé P de l'ordre de 150nm si l'épaisseur de la couche de blocage est de 25nm et l'épaisseur d'un puits quantique de l'ordre de 10nm. La valeur $k_d$ est alors choisie de manière à permettre de former le reste des couches composant la région active et la couche en matériau semi-conducteur dopé du premier type dont l'épaisseur est d'au minimum 100nm.

Dans la présente description, par « de l'ordre de », on entend à 10% près.

L'architecture de diode électroluminescente illustrée en figure 1 correspond notamment à une diode à configuration à couche mince plus connue dans le domaine sous le sigle VTF pour « Vertical Thin Film » en langue anglaise. Cependant, l'invention peut aussi s'appliquer à d'autres structures comme par exemple celle illustrée en figure 9 de structure TFFC (sigle de l'anglais « Thin Film Flip Chip ») pour laquelle la première électrode 5 et la deuxième électrode 6 sont accessibles depuis un même côté de la diode électroluminescente 1, la partie amincie 12 de l'empilement 2 étant représentée entre les lignes en pointillés l1 et l2. Sur la figure 9, il est représenté un substrat 14 sur lequel est reportée la diode électroluminescente 1 après sa formation sur un substrat sacrificiel non visible en figure 9 car retiré de sorte à permettre la formation de l'évidement 11. Le substrat 14 comporte donc des bornes de connexion 14a, 14b venant en contact chacune avec l'une des première et deuxième électrodes 5, 6 correspondantes. Comme évoqué précédemment, le niveau du fond 11b est inférieur au niveau de la deuxième électrode 6 en figure 9 (c'est-à-dire que le niveau du fond 11b est situé entre le niveau de la première électrode 5 et le niveau de la deuxième électrode 6) pour satisfaire les conditions liées à la longueur de dispersion du courant vis-à-vis du dimensionnement latéral de l'évidement 11.

De manière générale, les lignes l1 et l2 représentées aux figures 1 et 6 à 9 représentent virtuellement des limites de la partie amincie 12 de l'empilement 2 en contact avec la première électrode 5 et permettant de visualiser l'évidement 11, le fond 11b, l'ouverture 11a et la paroi 11c. Sur les figures 1 à 3 et 6 à 10, l'empilement 2 illustré comporte la couche 7 en matériau dopé de second type, la couche 9 en matériau dopé du premier type, la région active 8, la couche de blocage 10 de la diode électroluminescente 1.

La diode électroluminescente décrite ci-avant est destinée à émettre un rayonnement électromagnétique, c'est-à-dire des photons, lorsqu'elle est en fonctionnement. La longueur d'onde de fonctionnement de la diode n'est pas limitée aux longueurs d'onde visibles. En effet, l'homme du métier pourra adapter l'empilement pour centrer l'émission de la diode électroluminescente sur une longueur d'onde autre que le visible.

La diode électroluminescente peut aussi comporter au moins un miroir de Bragg. La structure d'un miroir de Bragg est connue et ne sera pas détaillée ici. Par exemple, la diode électroluminescente 1 peut comporter (figure 10) un miroir de Bragg 15 agencé dans l'évidement 11, par exemple au moins sur le fond 11b de l'évidement 11 de sorte que le miroir de Bragg soit en contact avec la couche 9 en matériau semi-conducteur dopé de premier type. Le positionnement du miroir de Bragg 15 dans l'évidement 11 permet de favoriser une émission directive de la diode électroluminescente 1. Alternativement, ou en combinaison avec, le miroir de Bragg agencé dans l'évidement 11, la diode électroluminescente 1 peut aussi comporter un miroir de Bragg 16 agencé sur la première électrode 5, notamment sur une face de la première électrode opposée à la face 5a de la première électrode 5 en contact avec l'empilement 2 et orientée vers la région active 8. L'agencement du miroir de Bragg 16 en contact avec la première électrode 5 permet de renvoyer des photons atteignant la première électrode 5 vers l'évidement 11. Le miroir de Bragg 16 est notamment utilisé si la première électrode 5 est transparente ou semitransparente. Les miroirs de Bragg permettent d'augmenter la réflectivité de la diode électroluminescente à l'interface où ils sont situés, et par voie de conséquence d'accroître l'intensité des interférences constructives.

La diode électroluminescente décrite selon la présente invention permet en outre de favoriser une émission directive de photons, même si le ou les miroir(s) de Bragg évoqué(s) ci-dessus ne sont pas présents.

Par ailleurs, la diode électroluminescente peut aussi comporter tout dispositif permettant d'améliorer la réflectivité de l'interface de l'empilement avec la première électrode ou de l'interface air/semi-conducteur en formant, par exemple, un miroir de Bragg comme mentionné ci-avant ou des cristaux photoniques en matériau semi-conducteur dans l'évidement, notamment sur le fond de l'évidement. Selon un autre exemple, au moins le fond de l'évidement peut être recouvert d'une couche (formant une « capping layer » en langue anglaise) en un matériau présentant un indice de réfraction supérieur à l'indice optique du matériau utilisé pour former la couche 9 en matériau semi-conducteur dopé de premier type.

La présente invention peut avoir des applications industrielles comme dans l'éclairage, ou l'affichage, où une diode électroluminescente telle que décrite peut être utilisée.

En particulier, la présente invention est tout particulièrement adaptée pour former une matrice de diodes électroluminescentes dédiée à l'affichage, ou à la visualisation, car le contraste est accru. Notamment, lorsque, pour chaque diode électroluminescente, la cathode est formée sur la deuxième face de l'empilement et entoure en tout ou partie l'ouverture de l'évidement, cela permet d'éviter la diaphonie (ou « crosstalk »).

De manière générale, pour accroître le contraste d'une diode électroluminescente lorsque la cathode est située sur la deuxième face de l'empilement, une couche de chrome peut être agencée sur la cathode de sorte que la cathode se retrouve prise entre la couche de chrome et la couche en matériau semi-conducteur dopé de premier type.

Un autre avantage de la présente invention, est qu'une telle diode peut être fabriquée tout en limitant le nombre de masques nécessaires du fait de l'alignement possible de l'anode, plus généralement la première électrode 5, avec l'évidement. Par ailleurs, un même masque peut être utilisé pour réaliser la cathode, plus généralement la deuxième électrode, et l'évidement.

## Revendications

1.  Diode électroluminescente (1) comportant :

    - un empilement (2) de couches semi-conductrices comprenant une première face (3) et une deuxième face (4) opposées selon une épaisseur de l'empilement (2),
    - une première électrode (5) comportant une face (5a) en contact avec la première face (3) de l'empilement (2), et
    - une deuxième électrode (6) en contact avec l'empilement (2), l'empilement (2) comportant une région active (8) apte à générer des photons, une couche (9) en matériau semi-conducteur dopé de premier type et une couche (7) en matériau semi-conducteur dopé de second type, un évidement (11) étant formé dans la deuxième face (4) de l'empilement (2) d'où il résulte que l'empilement (2) comporte une partie amincie (12), la face (5a) de la première électrode (5) en contact avec la première face (3) étant en contact uniquement avec la partie amincie (12) de l'empilement (2), la deuxième électrode (6) étant en contact avec une zone de l'empilement (2) distincte de ladite partie amincie (12) de l'empilement (2), l'empilement (2) présentant une première épaisseur (d1) entre ses première et deuxième faces (3, 4) et une deuxième épaisseur d entre un fond (11b) de l'évidement (11) et la première face (3), la deuxième épaisseur d étant strictement inférieure à la première épaisseur, la partie amincie (12) de l'empilement (2) comportant une première partie reliant la première électrode (5) à une zone située dans la région active (8) de l'empilement (2) et une deuxième partie s'étendant de la première partie jusqu'au fond (11b) de l'évidement (11), **caractérisée en ce que** l'évidement (11) est formé dans la couche (9) en matériau semi-conducteur dopé de premier type qui présente une conductivité électrique strictement supérieure à la conductivité électrique de la couche (7) en matériau semi-conducteur dopé de second type, et **en ce que** la deuxième épaisseur d satisfait l'équation suivante :

$$d = z + L$$

avec $z = k_z \cdot \dfrac{\lambda}{2n}$, $d = k_d \cdot \dfrac{\lambda}{2n}$, et $L$ étant tel que $\dfrac{\lambda}{2n} \cdot (k_d - k_z) = L$ avec $k_d > k_z$, $k_d$ et $k_z$ étant des entiers positifs différents de 0, $\lambda$ étant une longueur d'onde d'émission principale en fonctionnement de la diode électroluminescente, et n étant un indice optique de l'empilement (2) déterminé à la longueur d'onde d'émission principale, la première partie présentant une épaisseur égale à z et la deuxième partie présentant une épaisseur égale à $L$.

**2.** Diode électroluminescente (1) selon la revendication 1, **caractérisée en ce que** l'évidement (11) délimite ladite partie amincie (12) de l'empilement (2) avec une partie (13) de la première face (3), et **en ce que** la face (5a) de la première électrode (5) en contact avec la partie amincie (12) de l'empilement (2) présente une aire inférieure ou égale à l'aire de ladite partie (13) de la première face (3).

**3.** Diode électroluminescente (1) selon l'une quelconque des revendications 1 à 2, **caractérisée en ce que** $k_z$ est strictement supérieur à 1 et strictement inférieur à 6, $k_d$ est strictement inférieur à 10, et **en ce que** $k_z$ est tel que la couche (7) en matériau semi-conducteur dopé de second type présente, au sein de la partie amincie (12), une épaisseur supérieure ou égale à 50nm, et **en ce que** $k_d$ est tel que la couche (9) en matériau semi-conducteur dopé de premier type présente, entre le fond (11b) de l'évidement (11) et une face de ladite couche (9) en matériau semi-conducteur dopé de premier type orientée vers la couche (7) en matériau semi-conducteur dopé de second type, une épaisseur supérieure ou égale à 100nm.

**4.** Diode électroluminescente (1) selon l'une quelconque des revendications précédentes, **caractérisée en ce que** la région active (8) comporte plusieurs couches actives (8b) permettant chacune la recombinaison de porteurs de charge, et **en ce que** la zone située dans la région active (8) est située dans la couche active (8b) la plus proche de la première électrode (5).

**5.** Diode électroluminescente (1) selon l'une quelconque des revendications précédentes, **caractérisée en ce que** l'évidement (11) est délimité par une ouverture (11a) de l'évidement formée dans la deuxième face (4), un fond (11b) de l'évidement (11) et une paroi (11c) de l'évidement (11) reliant le fond (11b) à l'ouverture (11a).

**6.** Diode électroluminescente (1) selon la revendication précédente, **caractérisée en ce que** l'ouverture (11a) présente des dimensions inférieures aux dimensions de l'évidement (11) mesurées dans un plan situé entre l'ouverture (11a) et le fond (11b) de l'évidement (11), et **en ce que** l'ouverture (11a) présente une aire supérieure ou égale à celle de ladite face (5a) de la première électrode (5).

**7.** Diode électroluminescente (1) selon la revendication 5, **caractérisée en ce que** la paroi (11c) comporte, selon un plan de coupe perpendiculaire au fond (11b), un contour concave.

**8.** Diode électroluminescente (1) selon l'une quelconque des revendications précédentes, **caractérisée en ce qu'**elle présente une longueur de dispersion du courant, et **en ce que**, orthogonalement à une direction d'empilement des couches semi-conductrices de l'empilement (2), l'évidement (11) présente une dimension ($d_{ev}$) comprise entre une fois et cinq fois la longueur de dispersion du courant de la diode électroluminescente (1).

**9.** Procédé d'élaboration d'une diode électroluminescente (1), ladite diode électroluminescente (1) à élaborer comportant :

- un empilement (2) de couches semi-conductrices comprenant une première face (3) et une deuxième face (4) opposées selon une épaisseur de l'empilement (2),
- une première électrode (5) comportant une face (5a) en contact avec la première face (3) de l'empilement (2), et
- une deuxième électrode (6),

l'empilement (2) comportant une région active (8) apte à générer des photons, une couche (9) en matériau semi-conducteur dopé de premier type et une couche (7) en matériau semi-conducteur dopé de second type, le procédé d'élaboration comportant une étape de conception (E1) de l'empilement (2) dont la deuxième face (4) présente un évidement (11) pour former une partie amincie (12) de l'empilement (2), l'étape de conception (E1) prenant en compte les caractéristiques suivantes :

- ladite face (5a) de la première électrode (5) de la diode électroluminescente (1) est destinée à être en contact uniquement avec la partie amincie (12) de l'empilement (2),
- la deuxième électrode (6) de la diode électroluminescente est destinée à être en contact avec une zone de l'empilement (2) distincte de ladite partie amincie (12) de l'empilement (2),

**caractérisé en ce que** :

- l'évidement (11) est formé dans la couche (9) en matériau semi-conducteur dopé de premier type qui présente une conductivité électrique strictement supérieure à la conductivité électrique de la couche (7) en matériau semi-conducteur dopé de second type,
- l'étape de conception (E1) prend en compte le fait que la partie amincie (12) de l'empilement (2) comporte une première partie reliant la première électrode (5) à une zone située dans la région active (8) de l'empilement (2) et une deuxième partie s'étendant de la première partie jusqu'au fond (11b) de l'évidement (11),
- l'étape de conception (E1) de l'empilement (2) comporte les étapes suivantes :

    o une étape de détermination (E1-1) d'une longueur d'onde d'émission principale $\lambda$ de la diode électroluminescente (1) lors de son fonctionnement,
    o une étape de détermination (E1-2), à la longueur d'onde d'émission principale, d'un indice optique $n$ de l'empilement (2),
    o une étape de détermination (E1-3) d'une épaisseur d de la partie amincie (12) entre la première face (3) et un fond (11b) de l'évidement (11), l'épaisseur d satisfaisant d = $z$ + L avec $z = k_z \cdot \frac{\lambda}{2n}$ , $d = k_d \cdot \frac{\lambda}{2n}$ , et L étant tel que $\frac{\lambda}{2n} \cdot (k_d - k_z) = L$ avec $k_d > k_z$, $k_d$ et $k_z$ étant des entiers positifs différents de 0, la première partie présentant une épaisseur égale à z et la deuxième partie présentant une épaisseur égale à L.

10. Procédé d'élaboration selon la revendication 9, **caractérisé en ce que** l'étape de détermination (E1-3) de l'épaisseur d comporte une étape de choix de la valeur de $k_z$, $k_z$ devant être strictement supérieur à 1 et strictement inférieur à 6, et une étape de choix de la valeur $k_d$, $k_d$ devant être strictement inférieur à 10.

11. Procédé d'élaboration selon l'une quelconque des revendications 9 à 10, **caractérisé en ce que** l'étape de conception (E1) de l'empilement (2) comporte une étape de détermination (E1-4) d'une longueur de dispersion du courant de la diode électroluminescente (1), et une étape de dimensionnement (E1-5) de l'évidement (11) de sorte que, orthogonalement à une direction d'empilement des couches semi-conductrices de l'empilement (2), ledit évidement (11) présente une dimension ($d_{ev}$) comprise entre une fois et cinq fois la longueur de dispersion du courant de la diode électroluminescente (1).

**Patentansprüche**

1. Leuchtdiode (1), aufweisend:

- einen Stapel (2) aus halbleitenden Schichten, umfassend eine erste Fläche (3) und eine zweite Fläche (4), die gemäß einer Dicke des Stapels (2) gegenüberliegen,
- eine erste Elektrode (5), die eine Fläche (5a) im Kontakt mit der ersten Fläche (3) des Stapels (2) aufweist, und
- eine zweite Elektrode (6) im Kontakt mit dem Stapel (2),

wobei der Stapel (2) eine aktive Region (8), die imstande ist, Photonen zu erzeugen, eine Schicht (9) aus dotiertem halbleitendem Material ersten Typs und eine Schicht (7) aus dotiertem halbleitendem Material zweiten Typs aufweist, wobei eine Aussparung (11) in der zweiten Fläche (4) des Stapels (2) ausgebildet ist, woraus sich ergibt, dass der Stapel (2) einen verdünnten Teil (12) aufweist, wobei die Fläche (5a) der ersten Elektrode (5) im Kontakt mit der ersten Fläche (3) nur mit dem verdünnten Teil (12) des Stapels (2) im Kontakt ist, wobei die zweite Elektrode (6) mit einer Zone des Stapels (2) im Kontakt ist, die von dem verdünnten Teil (12) des Stapels (2) unterschiedlich ist, wobei der Stapel (2) eine erste Dicke (d1) zwischen seiner ersten und zweiten Fläche (3, 4) und eine zweite Dicke d zwischen einem Boden (11b) der Aussparung (11) und der ersten Fläche (3) aufweist, wobei die zweite Dicke d strikt kleiner als die erste Dicke ist, wobei der verdünnte Teil (12) des Stapels (2) einen ersten Teil aufweist, der die erste Elektrode (5) mit einer Zone verbindet, die sich in der aktiven Region (8) des Stapels (2) befindet, und einen zweiten Teil, der sich vom ersten Teil bis zum Boden (11b) der Aussparung (11) erstreckt, **dadurch gekennzeichnet,**

**dass** die Aussparung (11) in der Schicht (9) aus dotiertem halbleitendem Material ersten Typs ausgebildet ist, die eine elektrische Leitfähigkeit aufweist, die strikt größer als die elektrische Leitfähigkeit der Schicht (7) aus dotiertem halbleitendem Material zweiten Typs ist, und dass die zweite Dicke d der folgenden Gleichung entspricht:

$$d = z + L$$

mit $z = k_z \cdot \frac{\lambda}{2n}$, $d = k_d \cdot \frac{\lambda}{2n}$, und wobei $L$ derart ist, dass $\frac{\lambda}{2n} \cdot (k_d - k_z) = L$ mit $k_d > k_z$, wobei $k_d$ und $k_z$ positive Ganzzahlen unterschiedlich von 0 sind, $\lambda$ eine Hauptsendewellenlänge im Betrieb der Leuchtdiode ist und n ein bestimmter optischer Index des Stapels (2) in der Hauptsendewellenlänge ist, wobei der erste Teil eine Dicke gleich z aufweist und der zweite Teil eine Dicke gleich $L$ aufweist.

2. Leuchtdiode (1) nach Anspruch 1, **dadurch gekennzeichnet, dass** die Aussparung (11) den verdünnten Teil (12) des Stapels (2) mit einem Teil (13) der ersten Fläche (3) begrenzt und dass die Fläche (5a) der ersten Elektrode (5) im Kontakt mit dem verdünnten Teil (12) des Stapels (2) einen Bereich aufweist, der kleiner oder gleich dem Bereich des Teils (13) der ersten Fläche (3) ist.

3. Leuchtdiode (1) nach einem der Ansprüche 1 bis 2, **dadurch gekennzeichnet, dass** $k_z$ strikt größer als 1 und strikt kleiner als 6 ist, $k_d$ strikt kleiner als 10 ist und dass $k_z$ derart ist, dass die Schicht (7) aus dotiertem halbleitenden Material zweiten Typs innerhalb des verdünnten Teils (12) eine Dicke aufweist, die größer oder gleich 50 nm ist und dass $k_d$ derart ist, dass die Schicht (9) aus dotiertem halbleitenden Material ersten Typs zwischen dem Boden (11b) der Aussparung (11) und einer Fläche der Schicht (9) aus dotiertem halbleitenden Material ersten Typs, die zu der Schicht (7) aus dotiertem halbleitenden Material zweiten Typs zeigt, eine Dicke aufweist, die größer oder gleich 100 nm ist.

4. Leuchtdiode (1) nach einem der vorangehenden Ansprüche, **dadurch gekennzeichnet, dass** die aktive Region (8) mehrere aktive Schichten (8b) aufweist, die jede die Rekombination von Ladungsträgern erlaubt und dass sich die Zone, die sich in der aktiven Region (8) befindet, in der aktiven Schicht (8b) befindet, die der ersten Elektrode (5) am nächsten ist.

5. Leuchtdiode (1) nach einem der vorangehenden Ansprüche, **dadurch gekennzeichnet, dass** die Aussparung (11) von einer Öffnung (11a) der Aussparung begrenzt ist, die in der zweiten Fläche (4) ausgebildet ist, wobei ein Boden (11b) der Aussparung (11) und eine Wand (11c) der Aussparung (11) den Boden (11b) mit der Öffnung (11a) verbinden.

6. Leuchtdiode (1) nach vorangehendem Anspruch, **dadurch gekennzeichnet, dass** die Öffnung (11a) Abmessungen aufweist, die kleiner als die Abmessungen der Aussparung (11) sind, gemessen in einer Ebene, die sich zwischen der Öffnung (11a) und dem Boden (11b) der Aussparung (11) befindet, und dass die Öffnung (11a) einen Bereich aufweist, der größer oder gleich dem der Fläche (5a) der ersten Elektrode (5) ist.

7. Leuchtdiode (1) nach Anspruch 5, **dadurch gekennzeichnet, dass** die Wand (11c) gemäß einer Schnittebene senkrecht zum Boden (11b) eine konkave Kontur aufweist.

8. Leuchtdiode (1) nach einem der vorangehenden Ansprüche, **dadurch gekennzeichnet, dass** sie eine Dispersionslänge des Stroms aufweist und dass die Aussparung (11) orthogonal zu einer Stapelrichtung der halbleitenden Schichten des Stapels (2) eine Abmessung ($d_{ev}$) aufweist, die zwischen dem Ein- und Fünffachen der Dispersionslänge des Stroms der Leuchtdiode (1) liegt.

9. Verfahren zur Herstellung einer Leuchtdiode (1), wobei die herzustellende Leuchtdiode (1) Folgendes aufweist:

   - einen Stapel (2) aus halbleitenden Schichten, umfassend eine erste Fläche (3) und eine zweite Fläche (4), die gemäß einer Dicke des Stapels (2) gegenüberliegen,
   - eine erste Elektrode (5), die eine Fläche (5a) im Kontakt mit der ersten Fläche (3) des Stapels (2) aufweist, und
   - eine zweite Elektrode (6),

   wobei der Stapel (2) eine aktive Region (8), die imstande ist, Photonen zu erzeugen, eine Schicht (9) aus dotiertem halbleitendem Material ersten Typs und eine Schicht (7) aus dotiertem halbleitendem Material zweiten Typs aufweist, wobei das Herstellungsverfahren einen Schritt des Konzipierens (E1) des Stapels (2) aufweist, dessen zweite Fläche (4) eine Aussparung (11) aufweist, um einen verdünnten Teil (12) des Stapels (2) zu bilden, wobei der Schritt des Konzipierens (E1) die folgenden Merkmale berücksichtigt:

- die Fläche (5a) der ersten Elektrode (5) der Leuchtdiode (1) ist bestimmt, nur mit dem verdünnten Teil (12) des Stapels (2) im Kontakt zu sein,
- die zweite Elektrode (6) der Leuchtdiode ist bestimmt, mit einer Zone des Stapels (2) im Kontakt zu sein, die von dem verdünnten Teil (12) des Stapels (2) unterschiedlich ist,

**dadurch gekennzeichnet, dass**:

- die Aussparung (11) in der Schicht (9) aus dotiertem halbleitendem Material ersten Typs ausgebildet ist, die eine elektrische Leitfähigkeit aufweist, die strikt größer als die elektrische Leitfähigkeit der Schicht (7) aus dotiertem halbleitendem Material zweiten Typs ist,
- der Schritt des Konzipierens (E1) die Tatsache berücksichtigt, dass der verdünnte Teil (12) des Stapels (2) einen ersten Teil aufweist, der die erste Elektrode (5) mit einer Zone verbindet, die sich in der aktiven Region (8) des Stapels (2) befindet, und einen zweiten Teil, der sich vom ersten Teil bis zum Boden (11b) der Aussparung (11) erstreckt,
- der Schritt des Konzipierens (E1) des Stapels (2) die folgenden Schritte aufweist:

  ○ einen Schritt des Bestimmens (E1-1) einer Hauptsendewellenrichtung $\lambda$ der Leuchtdiode (1) im Betrieb,
  ○ einen Schritt des Bestimmens (E1-2), in der einer Hauptsendewellenrichtung, eines optischen Index n des Stapels (2),
  ○ einen Schritt des Bestimmens (E1-3) einer Dicke d des verdünnten Teils (12) zwischen der ersten Fläche (3) und einem Boden (11b) der Aussparung (11), wobei die Dicke *d* gleich d = z + L ist mit $z = k_z \cdot \dfrac{\lambda}{2n}$ , $d = k_d \cdot \dfrac{\lambda}{2n}$ , und wobei *L* derart ist, dass $\dfrac{\lambda}{2n} \cdot (k_d - k_z) = L$ mit $k_d > k_z$ ist, wobei $k_d$ und $k_z$ positive Ganzzahlen unterschiedlich von 0 sind, wobei der erste Teil eine Dicke gleich z aufweist und der zweite Teil eine Dicke gleich *L* aufweist.

**10.** Herstellungsverfahren nach Anspruch 9, **dadurch gekennzeichnet, dass** der Schritt des Bestimmens (E1-3) der Dicke d einen Schritt des Wählens des Wertes von $k_z$ aufweist, wobei $k_z$ strikt größer als 1 und strikt kleiner als 6 sein muss, und einen Schritt des Wählens des Wertes $k_d$, wobei $k_d$ strikt kleiner als 10 sein muss.

**11.** Herstellungsverfahren nach einem der Ansprüche 9 bis 10, **dadurch gekennzeichnet, dass** der Schritt des Konzipierens (E1) des Stapels (2), einen Schritt des Bestimmens (E1-4) einer Dispersionslänge des Stroms der Leuchtdiode (1) und einen Schritt des Dimensionierens (E1-5) der Aussparung (11) derart aufweist, dass die Aussparung (11) orthogonal zu einer Stapelrichtung der halbleitenden Schichten des Stapels (2) eine Dimension ($d_{ev}$) aufweist, die zwischen dem Ein- und Fünffachen der Dispersionslänge des Stroms der Leuchtdiode (1) liegt.

**Claims**

**1.** Light-emitting diode (1) comprising:

- a stack (2) of semiconductor layers including a first face (3) and a second face (4) that are opposite one another relative to a thickness of the stack (2),
- a first electrode (5) comprising a face (5a) in contact with the first face (3) of the stack (2), and
- a second electrode (6) in contact with the stack (2),

the stack (2) comprising an active region (8) able to generate photons, a layer (9) of semiconductor material with doping of a first type and a layer (7) of semiconductor material with doping of a second type, a recess (11) being formed in the second face (4) of the stack (2) which results in that the stack (2) comprises a thinned part (12), the face (5a) of the first electrode (5) in contact with the first face (3) being in contact only with the thinned part (12) of the stack (2), the second electrode (6) being in contact with a zone of the stack (2) separate from said thinned part (12) of the stack (2), the stack (2) having a first thickness (d1) between its first and second faces (3, 4) and a second thickness d between a bottom (11b) of the recess (11) and the first face (3), the second thickness d being strictly less than the first thickness, the thinned part (12) of the stack (2) comprising a first part linking the first electrode (5) to a zone located in the active region (8) of the stack (2) and a second part extending from the first part to the bottom (11b) of the recess (11), **characterized in that** the recess (11) is formed in the layer (9) of semiconductor material with doping of a first type that has an electrical conductivity strictly greater than the electrical conductivity of the layer (7) of semiconductor material with doping of a second type, and **in that** the second thickness d satisfy the following equation:

$$d = z + L$$

where $z = k_z \cdot \dfrac{\lambda}{2n}$ , $d = k_d \cdot \dfrac{\lambda}{2n}$ , and L being such that $\dfrac{\lambda}{2n} \cdot (k_d - k_z) = L$ where $k_d > k_z$ , $k_d$ and $k_z$ being positive integers other than 0, $\lambda$ being a main emission wavelength during operation of the light-emitting diode, and n being an optical index of the stack (2) determined at the main emission wavelength, the first part having a thickness equal to z and the second part having a thickness equal to $L$.

2. Light-emitting diode (1) according to Claim 1, **characterized in that** the recess (11) delimits said thinned part (12) of the stack (2) with a part (13) of the first face (3), and **in that** the face (5a) of the first electrode (5) in contact with the thinned part (12) of the stack (2) has an area smaller than or equal to the area of said part (13) of the first face (3).

3. Light-emitting diode (1) according to any one of Claims 1 to 2, **characterized in that** $k_z$ is strictly greater than 1 and strictly less than 6, $k_d$ is strictly less than 10, and **in that** $k_z$ is such that the layer (7) of semiconductor material with doping of a second type has, within the thinned part (12), a thickness greater than or equal to 50 nm, and **in that** $k_d$ is such that the layer (9) of semiconductor material with doping of a first type has, between the bottom (11b) of the recess (11) and a face of said layer (9) of semiconductor material with doping of a first type, which face is oriented towards the layer (7) of semiconductor material with doping of a second type, a thickness greater than or equal to 100 nm.

4. Light-emitting diode (1) according to any one of the preceding claims, **characterized in that** the active region (8) comprises a plurality of active layers (8b) each allowing the recombination of charge carriers, and **in that** the zone located in the active region (8) is located in the active layer (8b) closest to the first electrode (5).

5. Light-emitting diode (1) according to any one of the preceding claims, **characterized in that** the recess (11) is delimited by an aperture (11a) of the recess, which aperture is formed in the second face (4), a bottom (11b) of the recess (11) and a wall (11c) of the recess (11) linking the bottom (11b) to the aperture (11a).

6. Light-emitting diode (1) according to the preceding claim, **characterized in that** the aperture (11a) has dimensions smaller than the dimensions of the recess (11) as measured in a plane located between the aperture (11a) and the bottom (11b) of the recess (11), and **in that** the aperture (11a) has an area greater than or equal to that of said face (5a) of the first electrode (5).

7. Light-emitting diode (1) according to Claim 5, **characterized in that** the wall (11c) comprises, in a sectional plane perpendicular to the bottom (11b), a concave profile.

8. Light-emitting diode (1) according to any one of the preceding claims, **characterized in that** it has a current spreading length and **in that**, orthogonally to a stacking direction of the semiconductor layers of the stack (2), the recess (11) has a dimension ($d_{ev}$) comprised between once and five times the current spreading length of the light-emitting diode (1).

9. Method for developing a light-emitting diode (1), said light-emitting diode (1) to be developed comprising:

    - a stack (2) of semiconductor layers including a first face (3) and a second face (4) that are opposite one another relative to a thickness of the stack (2),
    - a first electrode (5) comprising a face (5a) in contact with the first face (3) of the stack (2), and
    - a second electrode (6),

the stack (2) comprising an active region (8) able to generate photons, a layer (9) of semiconductor material with doping of a first type and a layer (7) of semiconductor material with doping of a second type, the development method comprising a step (E1) of designing the stack (2) whose second face (4) has a recess (11) so as to form a thinned part (12) of the stack (2), the step (E1) of designing taking into account the following features:

- said face (5a) of the first electrode (5) of the light-emitting diode (1) is intended to be in contact only with the thinned part (12) of the stack (2),
- the second electrode (6) of the light-emitting diode is intended to be in contact with a zone of the stack (2) separate from said thinned part (12) of the stack (2),

**characterized in that**:

- the recess (11) is formed in the layer (9) of semiconductor material with doping of a first type that has an electrical conductivity strictly greater than the electrical conductivity of the layer (7) of semiconductor material with doping of a second type,
- the step (E1) of designing takes into account the fact that the thinned part (12) of the stack (2) comprises a first part linking the first electrode (5) to a zone located in the active region (8) of the stack (2) and a second part extending from the first part to the bottom (11b) of the recess (11),
- the step (E1) of designing the stack (2) comprises the following steps:

o a step (E1-1) of determining a main emission wavelength $\lambda$ of the light-emitting diode (1) during operation thereof,
o a step (E1-2) of determining, at the main emission wavelength, an optical index n of the stack (2),
o a step (E1-3) of determining a thickness d of the thinned part (12) between the first face (3) and a bottom (11b) of the recess (11), the thickness d satisfying d = z + L where $z = k_z \cdot \frac{\lambda}{2n}$ , $d = k_d \cdot \frac{\lambda}{2n}$ , and L being such that $\frac{\lambda}{2n} \cdot (k_d - k_z) = L$ where $k_d > k_z$, $k_d$ and $k_z$ being positive integers other than 0, the first part having a thickness equal to z and the second part having a thickness equal to L.

10. Development method according to Claim 9, **characterized in that** the step (E1-3) of determining the thickness d comprises a step of choosing the value of $k_z$, $k_z$ having to be strictly greater than 1 and strictly less than 6, and a step of choosing the value $k_d$, $k_d$ having to be strictly less than 10.

11. Development method according to any one of Claims 9 to 10, **characterized in that** the step (E1) of designing the stack (2) comprises a step (E1-4) of determining a current spreading length of the light-emitting diode (1), and a step (E1-5) of dimensioning the recess (11) such that, orthogonally to a stacking direction of the semiconductor layers of the stack (2), said recess (11) has a dimension ($d_{ev}$) comprised between once and five times the current spreading length of the light-emitting diode (1).

**Figure 1**

**Figure 2**

**Figure 3**

Y
Z
X

11a

11

6

1

4

**Figure 4**

Z
Y
X

9

8

8b

10

8d    8c

**Figure 5**

1

12    11    11c    6

4    11a    11b    9

I1    I2    2

Z
Y
X

8

10    7

5

**Figure 6**

**Figure 7**

**Figure 8**

**Figure 9**

**Figure 10**

**Figure 11**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4990972 A
- US 20020047131 A1
- JP H0786635 A
- EP 2846366 A1
- US 4700210 A
- US 20020113235 A1
- US 20120037885 A1

**Littérature non-brevet citée dans la description**

- **T. FUJII et al.** Increase in the extraction efficiency of GaN-based light-emitting diodes via surface roughening. *Applied Physics Letters,* 09 Février 2004, vol. 84 (6), 855-857
- **X. H. WANG et al.** Evaluation of InGaN/GaN light-emitting diodes of circular geometry. *Optics Express,* 2009, vol. 17 (25), 22311-22319
- **R. G. BAETS et al.** Resonant-Cavity Light-Emitting Diodes: a review. *Proceedings of SPIE,* 09 Juillet 2003, vol. 4996, 74-86